(19) **Europäisches Patentamt European Patent Office Office européen des brevets**

(11) **EP 3 944 278 B1**

(12) **FASCICULE DE BREVET EUROPEEN**

(45) Date de publication et mention de la délivrance du brevet:
**01.05.2024 Bulletin 2024/18**

(21) Numéro de dépôt: **21186328.7**

(22) Date de dépôt: **19.07.2021**

(51) Classification Internationale des Brevets (IPC):
**H01H 47/00** *(2006.01)* **H01H 47/32** *(2006.01)*

(52) Classification Coopérative des Brevets (CPC):
**H01H 47/32; H01H 47/002;** H01H 2047/008; H01H 2047/009

(54) **PROCÉDÉ DE DIAGNOSTIC D'UN ÉTAT DE FONCTIONNEMENT D'UN APPAREIL DE COMMUTATION ÉLECTRIQUE ET APPAREIL DE COMMUTATION ÉLECTRIQUE POUR LA MISE EN OEUVRE D'UN TEL PROCÉDÉ**

VERFAHREN ZUR DIAGNOSE DES BETRIEBSZUSTANDS EINES ELEKTRISCHEN SCHALTGERÄTS UND ELEKTRISCHES SCHALTGERÄT ZUR UMSETZUNG DIESES VERFAHRENS

METHOD FOR DIAGNOSING A STATE OF OPERATION OF AN ELECTRICAL SWITCHING DEVICE AND ELECTRICAL SWITCHING DEVICE FOR IMPLEMENTING SUCH A METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.07.2020 FR 2007606**

(43) Date de publication de la demande:
**26.01.2022 Bulletin 2022/04**

(73) Titulaire: **Schneider Electric Industries SAS 92500 Rueil-Malmaison (FR)**

(72) Inventeurs:
• **DELBAERE, Stéphane 38240 MEYLAN (FR)**
• **ORBAN, Rémy 38410 SAINT MARTIN D'URIAGES (FR)**
• **FOLLIC, Stéphane 38660 LUMBIN (FR)**

(74) Mandataire: **Lavoix 62, rue de Bonnel 69448 Lyon Cedex 03 (FR)**

(56) Documents cités:
**EP-A1- 3 460 822 WO-A1-98/24106 WO-A1-2015/189027**

**Description**

La présente invention concerne un procédé de diagnostic d'un état de fonctionnement d'un appareil de commutation électrique et un appareil de commutation électrique pour la mise en oeuvre d'un tel procédé.

L'invention concerne plus particulièrement les contacteurs électriques.

De tels appareils de commutation électrique comportent un actionneur électromagnétique comprenant une bobine et sont configurés pour commuter entre un état ouvert et un état fermé, par exemple pour commander l'alimentation électrique d'une charge électrique. Généralement, les contacts électriques comprennent des contacts fixes et des contacts mobiles, ces derniers étant liés à une partie mobile de l'actionneur qui se déplace sous l'effet d'un champ magnétique créé par la bobine lorsque celle-ci est parcourue par un courant électrique adéquat. Pour garantir une pression de contact suffisante entre les contacts électriques, la partie mobile de l'actionneur effectue une sur-course entre le moment où les contacts mobiles entrent en contact avec les contacts fixes, et le moment ou l'actionneur est en position fermée stable. Cette sur-course correspond à un écrasement de contact.

À chaque cycle de commutation, le contacteur s'use sous l'effet de divers facteurs, par exemple les contacts électriques s'usent sous l'effet d'arcs électriques lors de l'ouverture des contacts électriques, l'usure du contacteur se manifestant par une perte d'écrasement de contact.

Il est souhaitable de pouvoir estimer automatiquement le niveau d'usure d'un contacteur lorsqu'il est en fonctionnement, afin de prévoir une maintenance adaptée au cours de la vie dudit contacteur et/ou de détecter l'apparition de dysfonctionnements.

Il est connu d'intégrer à l'actionneur électromagnétique un capteur de position, pour mesurer directement le déplacement des pièces mobiles de l'actionneur et en déduire l'écrasement de contact. Cependant un capteur supplémentaire engendre un coût supplémentaire, et il n'est pas toujours possible d'intégrer un nouveau capteur à un contacteur existant.

EP-2584575-A1 décrit une méthode de diagnostic d'usure basée sur des mesures du temps entre des pics de courant ou d'intensité circulant dans la bobine de l'actionneur au cours de la phase d'ouverture. Une telle méthode de diagnostic permet seulement de connaître l'instant du début du mouvement et l'instant de la fin du mouvement du noyau. Mais un inconvénient de cette méthode est qu'elle ne permet pas de remonter à la position précise du noyau au cours de la phase d'ouverture. Cela rend plus difficile l'obtention d'informations fiables sur l'état des contacts et donc sur l'état d'usure du contacteur.

WO-2015/189027-A1 décrit, par exemple, une méthode d'évaluation d'états d'un actionneur basée sur les variations de flux magnétique, mais cette méthode ne permet pas de remonter à la position précise du noyau au cours de la phase de fermeture.

C'est à ces problèmes qu'entend plus particulièrement remédier l'invention, en proposant un procédé de diagnostic qui soit plus précis.

À cet effet, l'invention concerne un procédé de diagnostic d'un état de fonctionnement d'un appareil de commutation électrique. L'appareil de commutation électrique est configuré pour être couplé à un conducteur électrique et comprend :

- des contacts séparables associés au conducteur électrique et pilotés par un actionneur électromagnétique comprenant une bobine reliée à un dispositif électronique de contrôle, qui est configuré pour appliquer une tension bobine de commande aux bornes de la bobine,
- des capteurs configurés pour mesurer la tension bobine et une intensité d'un courant bobine circulant dans la bobine,

dans laquelle le procédé comprend les étapes consistant à :

- recevoir un ordre d'ouverture de l'appareil de commutation, l'appareil de commutation étant initialement dans un état fermé, l'ordre d'ouverture étant reçu par le dispositif électronique de contrôle ;
- après avoir reçu l'ordre d'ouverture, commander l'ouverture de l'actionneur électromagnétique au moyen du dispositif électronique de contrôle ;
- pendant la commutation de l'appareil de commutation vers l'état ouvert, mesurer et enregistrer les valeurs de tension bobine et de courant bobine ;
- calculer et enregistrer des valeurs d'un flux magnétique traversant la bobine, par intégration des valeurs enregistrées du courant bobine, de la tension bobine et des valeurs de résistance et d'inductance de la bobine, préalablement enregistrées dans le dispositif électronique de contrôle.

Selon l'invention, le procédé comprend, en outre, l'étape consistant à :

- à partir des valeurs enregistrées de flux magnétique et de courant bobine, évaluer et enregistrer des positions d'un noyau de l'actionneur électromagnétique en fonction d'une table de données caractéristique de l'actionneur électromagnétique, la table de données étant préalablement enregistrée dans le dispositif électronique de contrôle et définissant une relation bijective entre la position du noyau, le flux magnétique et le courant bobine.

Grâce à l'invention, le flux magnétique est calculé tout au long de la phase de d'ouverture à partir des mesures de tension bobine et de courant bobine. Une valeur de la position du noyau mobile en est déduite à partir de la table de données, qui relie de façon bijective position du noyau, flux magnétique et courant bobine. L'évolution de la position du noyau mobile au cours de la phase d'ouverture est ainsi obtenue automatiquement, de manière précise, sans avoir à implanter de nouveau capteur spécifique tel qu'un capteur de position.

Selon des aspects avantageux mais non obligatoires de l'invention, un tel procédé de diagnostic peut incorporer une ou plusieurs des caractéristiques suivantes prises isolément ou selon toute combinaison techniquement admissible :

- l'étape de calcul du flux magnétique comprend une sous-étape initiale dite d'autocorrection, suivie d'une sous-étape de calcul, la sous-étape d'autocorrection consistant à, tant que le courant bobine est supérieur à un seuil bas, lui-même strictement supérieur à un courant dit « de décrochage » en deçà duquel le noyau mobile est repoussé en position ouverte par un organe de rappel de l'actionneur électromagnétique, évaluer et enregistrer une valeur initiale du flux magnétique, dite « flux initial », de manière que lorsque le courant bobine décroit en deçà du courant de décrochage, le calcul par intégration du flux magnétique au cours de la phase de calcul tient compte de la valeur du flux initial ;

- le dispositif électronique de contrôle est configuré pour, lorsque l'appareil de commutation est à l'état fermé, faire varier la tension bobine de manière que le courant bobine varie entre le seuil bas et un seuil haut, strictement supérieur au seuil bas, alors qu'après avoir reçu l'ordre d'ouverture, le dispositif électronique de contrôle commande l'ouverture de l'actionneur électromagnétique lorsque le courant bobine est supérieur ou égal à 80% du seuil haut, de préférence supérieur à 95%, de préférence encore supérieur à 98% ;

- la variation de tension bobine est faite de manière périodique, par exemple par hachage, le courant bobine variant aussi de façon périodique entre les seuils bas et haut, alors qu'après avoir reçu l'ordre d'ouverture, le dispositif électronique de contrôle commande l'ouverture de l'actionneur électromagnétique au plus tard au bout d'une durée prédéfinie après avoir reçu l'ordre d'ouverture, la durée prédéfinie étant égale à une période de la tension bobine ;

- le dispositif électronique de contrôle est configuré pour calculer un temps dit « de retombée », égal au temps écoulé entre l'instant où le dispositif électronique de contrôle commande l'ouverture de l'actionneur électromagnétique et l'instant où l'actionneur électromagnétique est en position ouverte ;

- le procédé comprend une étape consistant à calculer, par dérivation temporelle des valeurs de position de l'appareil de commutation enregistrées dans le dispositif électronique de contrôle, un profil de vitesse de déplacement de l'appareil de commutation et un profil d'accélération de l'appareil de commutation, et à enregistrer les profils de vitesse et d'accélération de l'appareil de commutation dans le dispositif électronique de contrôle ;

- le procédé comprend une étape consistant à calculer une valeur de vitesse dite « de séparation », égale à une vitesse de déplacement du noyau lorsque le noyau est dans une position dite « d'écrasement maximal » correspondant à un déplacement du noyau de sa position fermée vers sa position ouverte, sensiblement égal à 2 mm, et

- le procédé comprend une étape consistant à détecter, au cours de la phase d'ouverture de l'appareil de commutation, un minimum local de la vitesse du noyau entre le début du mouvement du noyau et le moment où le noyau arrive en butée en position ouverte.

L'invention concerne aussi un appareil de commutation électrique pour la mise en oeuvre d'un procédé de diagnostic tel que décrit précédemment, l'appareil de commutation comprenant :

- des contacts séparables, déplacés entre une position ouverte et une position fermée par un actionneur électromagnétique comprenant une bobine et un noyau mobile lié aux contacts séparables, l'appareil de commutation présentant une structure limitant la génération de courants d'induction ;

- un circuit de commande de la tension électrique aux bornes de la bobine, dite « tension bobine », le circuit de commande comprenant un dispositif dit « de retombée », activable sélectivement pour faire chuter le courant électrique circulant au travers de la bobine, dit « courant bobine », la tension bobine et le dispositif de retombée étant activés ou désactivés selon des états du circuit de commande ;

- des capteurs pour mesurer le courant bobine et la tension bobine ;

- un dispositif électronique de contrôle, configuré pour recevoir des ordres d'ouverture et de fermeture de l'appareil de commutation, pour recevoir les valeurs des mesures de courant bobine et de tension bobine et pour commander les états du circuit de commande ;

dans lequel l'appareil de commutation est configuré pour mettre en oeuvre un procédé de diagnostic comportant des étapes consistant à :

a) recevoir un ordre d'ouverture de l'appareil de commutation ;

b) commander l'ouverture de l'actionneur électromagnétique ;

c) mesurer et enregistrer les valeurs de tension bobine et de courant bobine ;

d) calculer et enregistrer des valeurs d'un flux magnétique traversant la bobine, par intégration des valeurs enregistrées du courant bobine, de la tension bobine et des valeurs, préalablement enregistrées dans le dispositif électronique de contrôle, de résistance et d'inductance de la bobine ;

e) évaluer et enregistrer des positions du noyau en fonction d'une table de données caractéristique de l'actionneur électromagnétique, la table de données étant préalablement enregistrée dans le dispositif électronique et définissant une relation bijective entre la position du noyau, le flux magnétique et le courant bobine.

Cet appareil de commutation induit les mêmes avantages que ceux mentionnés ci-dessus au sujet du procédé de diagnostic de l'invention.

L'invention sera mieux comprise, et d'autres avantages de celle-ci apparaîtront plus clairement à la lumière de la description qui va suivre, d'un mode de réalisation d'un procédé de diagnostic d'un état de fonctionnement d'un contacteur, et d'un contacteur configuré pour la mise en oeuvre d'un tel procédé, donnée uniquement à titre d'exemple et faite en référence aux dessins annexés, dans lesquels :

- [Fig 1] la figure 1 est une vue schématique d'un appareil de commutation électrique comportant un actionneur électromagnétique conforme à des modes de réalisation de l'invention ;
- [Fig 2] la figure 2 une vue schématique d'un exemple du circuit de commande de l'actionneur électromagnétique de l'appareil de commutation de la figure 1 ;
- [Fig 3] la figure 3 est un graphe représentant l'évolution d'un courant électrique de commande de l'actionneur électromagnétique de la figure 2 au cours de plusieurs phases de fonctionnement ;
- [Fig 4] la figure 4 est un graphe représentant, dans deux conditions différentes, l'évolution du courant électrique de commande de l'actionneur électromagnétique de la figure 2 au cours de deux phases de fonctionnement ;
- [Fig 5] la figure 5 est un graphe représentant l'évolution d'un courant électrique de commande et d'un flux magnétique de l'actionneur électromagnétique de la figure 2, mesurés au cours d'une phase d'ouverture de l'actionneur ;
- [Fig 6] la figure 6 est un graphe illustrant une des étapes du procédé de diagnostic ;
- [Fig 7] la figure 7 est un graphe illustrant un résultat d'un procédé de diagnostic de propriétés de l'appareil de commutation de la figure 1 conforme à des modes de réalisation de l'invention ;
- [Fig 8] la figure 8 est un graphe représentant l'évolution de la sensibilité du flux magnétique de l'actionneur électromagnétique la figure 2 en fonction du courant électrique de commande de l'actionneur électromagnétique ;
- [Fig 9] la figure 9 est un diagramme représentant des étapes d'un procédé de diagnostic de propriétés de l'appareil de commutation de la figure 1 conforme à des modes de réalisation de l'invention ;
- [Fig 10] la figure 10 est un graphe représentant un exemple de résultat du procédé selon l'invention au cours d'un phase d'ouverture de l'appareil de commutation de la figure 1 ;
- [Fig 11] la figure 11 est un graphe représentant un autre exemple de résultat du procédé selon l'invention au cours d'un phase d'ouverture de l'appareil de commutation de la figure 1, et
- [Fig 12] la figure 12 est un graphe représentant un autre exemple de résultat du procédé selon l'invention au cours d'un phase d'ouverture de l'appareil de commutation de la figure 1.

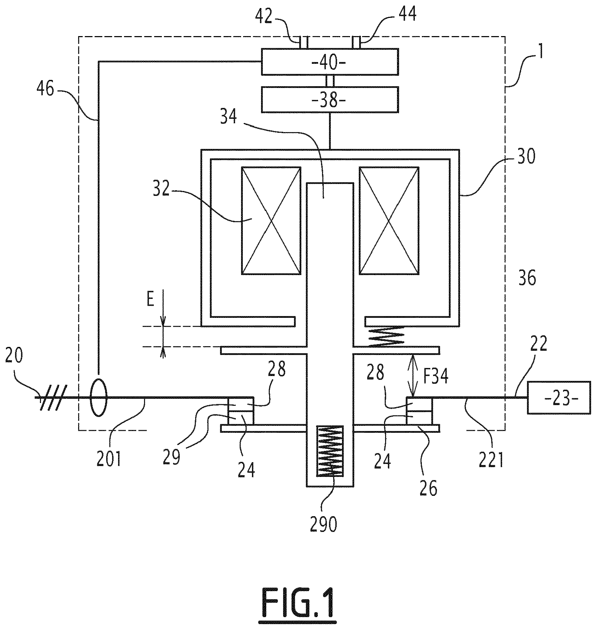

Un contacteur 1 est représenté sur la figure 1. Le contacteur 1 est un exemple d'appareil de commutation électrique destiné à commander l'alimentation en énergie électrique d'une source d'énergie électrique vers une charge électrique 23. La source d'énergie électrique n'est pas dessinée pour simplifier les figures. La source d'énergie est par exemple un réseau d'alimentation électrique, tandis que la charge électrique 23 est par exemple un moteur électrique, que l'on souhaite commander et/ou protéger au moyen du contacteur 1. Le contacteur 1 est généralement logé dans un boitier, représenté ici par un rectangle en pointillés. Le contacteur 1 est configuré pour être couplé, d'une part, à un conducteur électrique 20 amont connecté à une source d'énergie électrique et, d'autre part, à une ligne aval 22 connectée à la charge électrique 23. Lorsque le contacteur 1 laisse passer le courant électrique et que la charge électrique 23 est alimentée en énergie, le contacteur 1 est dans un état dit « fermé », tandis que lorsque le contacteur 1 empêche le passage de l'énergie électrique vers la charge électrique, le contacteur 1 est dans un état dit « ouvert ».

Le conducteur électrique 20 et la ligne aval 22 comprennent le même nombre de phases. Lorsque la source d'énergie électrique est polyphasée, les conducteurs électriques 20 et la ligne aval 22, qui comprennent chacune des fils conducteurs isolés les uns des autres, comptent autant de fils conducteurs l'un que l'autre, chaque fil conducteur de la ligne aval 22 étant associé à un fil respectif du conducteur électrique 20 amont. Quel que soit le nombre de phases, le contacteur 1 est configuré pour interrompre, ou faire passer, le courant électrique conjointement dans chacune des phases.

Dans l'exemple illustré, le conducteur électrique 20 amont est triphasé. Un seul des fils conducteurs du conducteur électrique 20, référencé 201, est représenté sur la figure 1. Seul le fil conducteur de la ligne de puissance 22 associé au conducteur 201 est représenté, ce fil conducteur de la ligne de puissance 22 étant référencé 221.

La suite de la description est faite en référence aux fils conducteurs 201 et 221, qui sont associés à une même phase du courant d'alimentation, sachant que ce qui est décrit peut être transposé aux autres phases du courant d'alimentation.

Pour chaque phase, le contacteur 1 comprend des contacts mobiles 24, disposés sur un barreau mobile 26, et des contacts fixes 28, liés respectivement aux conducteurs amont 20 et aval 22. Chacun des contacts mobiles 24 et fixes 28 comprend des pastilles de contact 29, réalisées ici en métal, de préférence en alliage d'argent ou tout matériau équivalent.

Le barreau mobile 26 est déplaçable entre une position fermée, dans laquelle les contacts mobiles 24 sont électriquement connectés aux contacts fixes 28 et l'énergie électrique peut circuler au travers du barreau mobile 26 du conducteur électrique 20 amont vers la ligne aval 22, et une position ouverte dans laquelle les contacts mobiles 24 sont éloignés des contacts fixes 28.

Lorsque le barreau mobile 26 est en position fermée, le contacteur 1 est à l'état fermé, tandis que lorsque le barreau 26 est en position ouverte, le contacteur 1 est à l'état ouvert. Le passage de l'état ouvert à l'état fermé est une phase de fermeture du contacteur 1, tandis que le passage de l'état fermé à l'état ouvert est une phase d'ouverture du contacteur 1.

En pratique, au cours de chaque cycle comprenant une phase de fermeture et d'ouverture, les pastilles de contact 29 s'usent, par exemple sous l'action d'arcs électriques au cours de l'ouverture, ou encore par arrachement de matière causé par des microsoudures. Cette perte de matière a pour conséquence que l'épaisseur des pastilles de contact 29 se réduit tout au long de la vie du contacteur 1, ce qui augmente l'amplitude du mouvement du barreau 26 lors des phases d'ouverture ou de fermeture. Pour y remédier, le contacteur 1 comprend un mécanisme 290, représenté schématiquement par un ressort sur la figure 1, qui est lié au barreau 26 et qui permet de maintenir les contacts fixes 28 et mobiles 24 en contact électrique avec une pression de contact suffisante.

Lorsque l'épaisseur des pastilles de contact 29 est insuffisante ou que l'état de surface des pastilles 29 est mauvais, les risques de dysfonctionnement du contacteur 1 augmentent et il convient de remplacer le contacteur 1 ; c'est pour ces raisons qu'un diagnostic de l'état d'écrasement des contacts du contacteur 1 permet d'évaluer l'avancement de la dégradation du contacteur 1.

Le barreau mobile 26 est piloté par un actionneur électromagnétique 30, qui comprend électroaimant de commande avec une bobine 32, un noyau 34 lié au barreau mobile 26 et un organe de rappel 36, par exemple un ressort ou équivalent. La bobine 32 est configurée pour générer un champ magnétique lorsqu'elle est alimentée par un courant électrique de commande, afin de mettre en mouvement le noyau 34, et donc le barreau mobile 26. Les mouvements du noyau 34 entre les positions ouverte et fermée sont représentés par une double flèche F34. Autrement dit, les contacts mobiles 24 et les contacts fixes 28 associés forment ensemble des contacts séparables, qui sont associés au conducteur électrique 20 et qui sont déplacés entre une position ouverte et une position fermée par l'actionneur électromagnétique 30, qui comprend une bobine 32 et un noyau mobile 34 lié aux contacts séparables.

Sur la figure 1, le contacteur 1 est représenté dans une configuration intermédiaire entre les états ouvert et fermé stable du contacteur 1, dans laquelle les contacts fixes 28 et mobiles 24 sont électriquement connectés, mais le noyau 34 n'est pas en butée en position fermée. Le mécanisme 290 autorise une sur-course du noyau 34 par rapport entre le moment où les contacts fixes 28 entrent en contact avec les contacts mobiles 24, et le moment où l'actionneur 30 est en position fermée stable. Cette sur-course, qui correspond à l'écrasement de contact, est notée E sur la figure 1.

L'actionneur électromagnétique 30 est commandé par l'intermédiaire d'un circuit d'alimentation 38, lui-même piloté par un dispositif électronique de contrôle 40. La bobine 32 est ainsi reliée au dispositif électronique de contrôle 40.

Selon des modes de réalisation, le dispositif électronique de contrôle 40 comporte une unité logique de calcul (CPU), telle qu'un microcontrôleur programmable ou un microprocesseur ou équivalent, et une mémoire informatique formant un support d'enregistrement de données lisibles par ordinateur.

Selon des exemples, la mémoire est une mémoire ROM, ou une mémoire RAM, ou une mémoire non volatile du type EPROM ou Flash ou équivalent. La mémoire comporte des instructions exécutables et/ou du code informatique pour assurer le fonctionnement du dispositif de contrôle 40 conformément à un ou plusieurs des modes de réalisation décrits ci-après lorsqu'exécuté par l'unité logique de calcul.

Selon des variantes, le dispositif électronique de contrôle 40 peut comporter un processeur de traitement du signal (DSP), ou un composant logique reprogrammable (FPGA), ou un circuit intégré spécialisé (ASIC), ou tout élément équivalent.

Le dispositif électronique de contrôle 40 est lui-même connecté à un rail d'alimentation 42 et comprend une interface 44 configurée pour recevoir, en provenance d'un utilisateur, des ordres d'ouverture ou de fermeture de l'appareil de commutation 1. Le dispositif électronique de contrôle 40 est ici représenté comme étant intégré au contacteur 1. En variante le dispositif de contrôle 40 est déporté, c'est-à-dire qu'il n'est pas intégré dans un même boitier que l'actionneur électromagnétique 30.

Le rail d'alimentation 42 présente une tension de préférence stable et continue et est destiné à alimenter en énergie le dispositif électronique de contrôle 40 ainsi que le circuit d'alimentation 38. L'interface 44 est représentée ici par des électrodes de commande. Par exemple, une tension électrique de commande peut être appliquée entre les électrodes de commande. Optionnellement, l'interface 44 comprend des moyens de communication sans fil.

Dans certains modes de réalisation, le contacteur 1 comprend aussi des capteurs de courant 46, configurés pour mesurer un courant circulant dans chacune des phases de la ligne amont 20, autrement dit un courant circulant dans chacun des fils conducteurs 201 de la ligne amont 20. Dans d'autres modes de réalisation, les capteurs de courant 46 et le dispositif électronique de contrôle 40 sont intégré dans un boîtier distinct du contacteur 1.

Lorsque la bobine 32 est alimentée en énergie électrique fournie par le rail d'alimentation 42, un courant d'excitation passe par la bobine 32, qui génère une force électromagnétique qui tend à attirer le noyau 34 et le barreau 26 de la position ouverte vers la position fermée. Un organe de rappel 36, représenté ici par un ressort, exerce une force de rappel qui s'oppose à la force d'attraction de l'électroaimant.

On définit un courant bobine $I_{BOB}$ comme étant un courant d'excitation circulant au travers de la bobine 32.

On définit un courant de décollage $I_D$ comme étant un seuil du courant bobine $I_{BOB}$ qui, lorsque l'actionneur 1 est à l'état ouvert, permet à l'actionneur 1 de se déplacer jusqu'à l'état fermé, dès que le courant bobine $I_{BOB}$ croit au-delà du courant de décollage $I_D$.

On définit un courant de décrochage $I_S$ - ou « *stall current* » en anglais - comme étant un seuil du courant bobine $I_{BOB}$ qui, lorsque l'actionneur 1 est à l'état fermé, permet à l'actionneur 1 de se déplacer jusqu'à l'état ouvert, dès que le courant bobine $I_{BOB}$ décroit en deçà du courant de décrochage $I_S$.

Ainsi, lorsque l'actionneur 1 est à l'état ouvert, tant que le courant bobine $I_{BOB}$ reste en-deçà du courant de décollage $I_D$, le noyau mobile 34 est repoussé en position ouverte par l'organe de rappel 36 de l'actionneur 30 et le contacteur 1 reste à l'état ouvert. Si le courant bobine $I_{BOB}$ croit au-delà du courant de décollage $I_D$, le noyau 34 se déplace alors de sa position ouverte vers sa position fermée. Une telle situation correspond à une phase de fermeture du contacteur 1.

À l'inverse, lorsque l'actionneur 1 est à l'état fermé, tant que le courant bobine $I_{BOB}$ reste supérieur au courant de décrochage $I_S$, le contacteur 1 reste à l'état fermé. Si le courant bobine $I_{BOB}$ décroit en-deçà du courant de décrochage $I_S$, la force électromagnétique de la bobine 32 devient plus faible que la force de rappel de l'organe 36 et du mécanisme 290, le noyau 34 est alors repoussé de sa position fermée vers sa position ouverte sous l'effet de l'organe de rappel 36 et du mécanisme 290. Une telle situation correspond à une phase d'ouverture du contacteur 1.

Généralement, le courant de décollage $I_D$ est supérieur, en valeur absolue, au courant de décrochage $I_S$. Les valeurs des courants de décollage $I_D$ et de décrochage $I_S$ sont ajustées lors de la conception de l'actionneur 1, en jouant notamment sur les propriétés de la bobine 32 ou sur les forces de rappel de l'organe 36 et du mécanisme 290.

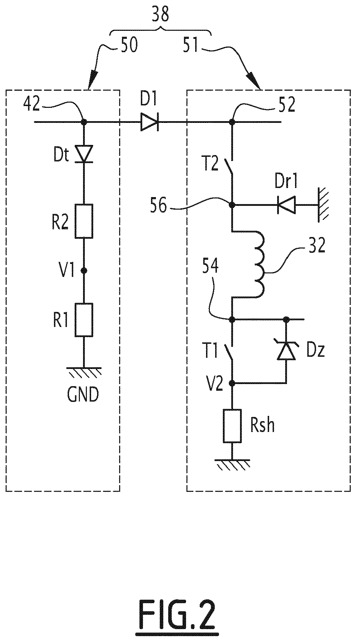

Un exemple de réalisation du circuit d'alimentation 38 est représenté schématiquement sur la figure 2. L'architecture du circuit d'alimentation 38 n'est pas limitative, et d'autres implantations des divers composants du circuit d'alimentation 38 sont possibles, voire d'autres composants électriques ou électroniques peuvent être utilisés pour remplir les mêmes fonctions.

Le circuit d'alimentation 38 comprend de préférence un circuit de mesure 50, délimité par un cadre en pointillés, configuré pour mesurer la valeur de la tension électrique entre le rail d'alimentation 42 et une masse électrique GND du circuit d'alimentation 38.

Par exemple, le circuit de mesure 50 comprend deux résistances R1 et R2 connectées en série avec une diode Dt entre le rail d'alimentation 42 et la masse électrique GND. Un premier point de mesure, ici placé entre les résistances R1 et R2, permet de collecter une première tension de mesure V1 représentative de la tension électrique présente entre le rail d'alimentation 42 et la masse électrique GND. La tension électrique présente entre le rail 42 et la masse GND étant reliée à la tension bobine $U_{BOB}$, par extension le circuit de mesure 50 est un exemple de capteur configuré pour mesurer la tension bobine $U_{BOB}$.

Le circuit d'alimentation 38 comprend un circuit de commande 51, qui inclut la bobine 32. Une diode D1 peut être placée sur le rail d'alimentation 42 entre le circuit de commande 51 et le circuit de mesure 50 pour éviter tout retour de courant vers ce dernier. Les diodes D1 et Dt sont de préférence de même type.

Le circuit de commande 51 est représenté ici dans une configuration dite « de retombée », qui est détaillée plus loin dans la présente description.

Le circuit de commande 51 comprend une borne d'alimentation 52, qui est reliée au rail d'alimentation 42. La bobine 32 comprend deux bornes 54 et 56. Une mesure de tension électrique entre les bornes 54 et 56 permet ainsi de mesurer une tension bobine, notée $U_{BOB}$.

La borne 54 est reliée à la masse GND par l'intermédiaire d'un interrupteur dit « de retombée » T1. Dans de nombreux modes de réalisation, une résistance dite « de shunt » Rsh est connectée en série avec l'interrupteur de retombée T1 pour collecter une deuxième tension de mesure V2 représentative du courant électrique traversant la bobine 32, autrement dit représentative du courant bobine $I_{BOB}$. Dans l'exemple illustré la résistance de shunt Rsh est connectée entre l'interrupteur de retombée T1 et la masse GND. La résistance Rsh est un exemple de capteur configuré pour mesurer l'intensité du courant bobine $I_{BOB}$ circulant dans la bobine 32.

La borne 56 est, d'une part, reliée à la borne 52 par l'intermédiaire d'un interrupteur d'alimentation T2 et, d'autre part, reliée à la masse GND par l'intermédiaire d'une diode, dite diode « de roue libre » Drl. La diode de roule libre Drl présente un sens bloquant orienté vers la borne 56.

Les interrupteurs T1 et T2 sont des interrupteurs pilotés par un signal de commande en provenance du dispositif électronique de contrôle 40. Autrement dit, le dispositif électronique de contrôle 40 est configuré pour commander des états du circuit de commande 51.

Selon des exemples de mise en oeuvre, les interrupteurs T1 et T2 sont des interrupteurs de puissance à semi-conducteurs, tels que des transistors Mosfet, ou des thyristors, ou des transistors bipolaires à grille isolée (IGBT), ou tout autre dispositif équivalent.

Le circuit de commande 51 comprend un dispositif « de retombée » Dz, réalisé ici au moyen d'une diode Zéner et connecté en parallèle à l'interrupteur de retombée T1. Ainsi, lorsque l'interrupteur de retombée T1 est ouvert, le courant bobine $I_{BOB}$ passe par le dispositif de retombée Dz, alors que lorsque l'interrupteur de retombée T1 est fermé, le dispositif de retombée Dz est en court-circuit et aucun courant ne passe par le dispositif de retombée Dz. Le dispositif de retombée Dz est ainsi activable sélectivement pour faire chuter le courant bobine $I_{BOB}$.

Dans le cadre de la présente invention, les grandeurs caractéristiques des composants du circuit d'alimentation 38 sont considérées comme connues. En particulier, la bobine 32 présente une résistance notée $R_{BOB}$ et une inductance notée $L_{BOB}$. La résistance $R_{BOB}$ et l'inductance $L_{BOB}$ dépendent, notamment, de la géométrie de la bobine 32, des matériaux utilisés, de la température, etc. Les valeurs des résistance $R_{BOB}$ et inductance $L_{BOB}$ sont ainsi considérées comme connues.

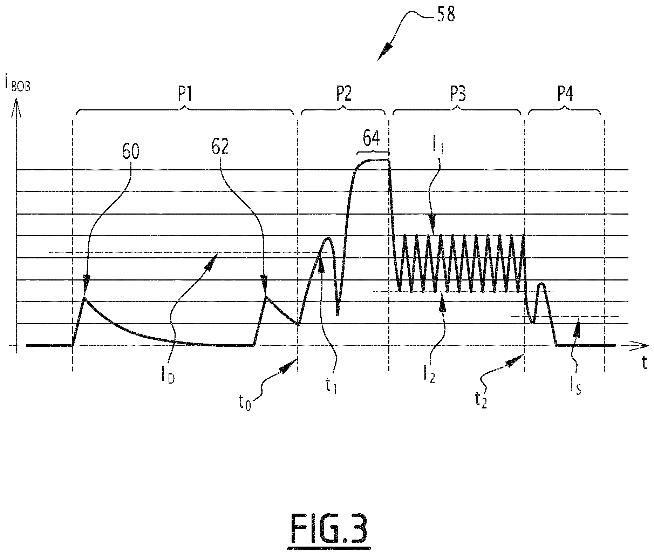

La figure 3 représente un graphique 58 illustrant l'évolution du courant bobine $I_{BOB}$ circulant dans la bobine 32 au cours du temps (t) lors de différentes phases de fonctionnement successives du contacteur 1, notées P1, P2, P3 et P4, dans le cas où le contacteur est commuté vers l'état fermé, puis à nouveau commuté vers l'état ouvert.

La phase P1 est une phase initiale, pendant laquelle le contacteur 1 est à l'état ouvert de façon stable, c'est-à-dire que le courant bobine $I_{BOB}$ ne dépasse pas le courant de décollage $I_D$. Sur la figure 3, le courant bobine $I_{BOB}$ présente des pics transitoires 60 et 62, qui sont inférieurs au courant de décollage $I_D$ et qui sont liés à des opérations de tests du contacteur 1, ces opérations de tests n'étant pas détaillées dans la présente description.

La phase P2 correspond à une phase de fermeture, après qu'un ordre de fermeture ait été reçu par le contacteur 1. La phase P2 commence lorsque le dispositif électronique de contrôle 40 reçoit, à un instant $t_0$, un ordre de fermeture par l'interface 44.

Le dispositif électronique de contrôle 40 est configuré pour appliquer la tension bobine $U_{BOB}$ de commande aux bornes de la bobine 32. Par exemple, le dispositif de contrôle 40 commande alors la fermeture de l'interrupteur de retombée T1 et de l'interrupteur d'alimentation T2. La tension bobine $U_{BOB}$ est alors égale à la tension délivrée par le rail d'alimentation 42, moins la tension aux bornes de la résistance de shunt Rsh. Le courant bobine $I_{BOB}$, initialement nul, croît alors pour dépasser le courant de décollage $I_D$ à un instant $t_1$, à partir duquel le noyau 34 commence à se déplacer de sa position ouverte vers sa position fermée.

Dans la suite de la phase de fermeture P2, les contacts mobiles 26 arrivent en appui sur les contacts fixes 28, le contacteur 1 est alors à l'état fermé. Le noyau 34 continue de se déplacer jusqu'à entrer en contact avec la partie fixe 30 du circuit magnétique, ce qui correspond à la course d'écrasement des contacts électriques.

Plus généralement, lorsque la source d'énergie électrique comprend plusieurs phases électriques, les pastilles 29 associées à chacune des phases électriques ne présentent pas toutes la même usure, autrement dit pas le même écrasement. L'instant exact de la fermeture de chacune des phases électriques diffère selon les phases électriques.

Au cours d'une dernière phase 64 de la phase de fermeture P2, les phénomènes transitoires sont terminés, et le courant bobine $I_{BOB}$ présente une valeur plateau, égale à la tension bobine $U_{BOB}$ divisée par la résistante bobine $R_{BOB}$ et strictement supérieure au courant de décrochage $I_S$. Le contacteur 1 est alors à l'état fermé de manière stable.

Au cours de la phase 64, la bobine 32 consomme de l'énergie électrique, en particulier par effet Joule, la puissance de l'énergie électrique consommée par la bobine 32 par effet Joule étant égale à $R_{BOB} \times (I_{BOB})^2$. Or le contacteur 1 reste à l'état fermé tant que le courant bobine $I_{BOB}$ est maintenu au-dessus du courant de décrochage $I_S$. Il est donc possible de réduire la consommation énergétique de la bobine 32 tout en maintenant contacteur 1 à l'état fermé de manière stable, en réduisant l'intensité du courant bobine $I_{BOB}$, tant que le courant bobine $I_{BOB}$ reste supérieur au courant de décrochage $I_S$.

Ceci est par exemple obtenu en faisant varier la tension bobine $U_{BOB}$, de manière à réduire le plus possible le courant bobine $I_{BOB}$ tout en le maintenant au-dessus du courant de décrochage $I_S$. Une telle situation correspond à la phase de maintien P3.

Dans l'exemple illustré, la variation de la tension bobine $U_{BOB}$ est obtenue en ouvrant et fermant alternativement l'interrupteur d'alimentation T2, ce qui crée un signal périodique de hachage de la tension bobine $U_{BOB}$ suivant un profil

en créneau et à une fréquence F3.

**[0064]** Au cours de la phase de maintien P3, lorsque l'interrupteur d'alimentation T2 est ouvert, l'interrupteur de retombée T1 reste fermé. Le circuit de commande 51 est alors dans un mode dit « roue libre », le circuit de commande 51 étant limité à la bobine 32 connectée à la diode de roue libre Drl et à la résistance de shunt Rsh. Le courant bobine $I_{BOB}$ décroit alors, l'énergie électrique étant principalement dissipée par la résistance $R_{BOB}$ de la bobine 32. L'interrupteur d'alimentation T2 est ensuite refermé avant que le courant bobine $I_{BOB}$ ne décroisse en deçà du courant de décrochage $I_S$, et le courant bobine $I_{BOB}$ croit à nouveau.

**[0065]** En résultat, le courant bobine $I_{BOB}$ varie périodiquement à une fréquence égale à la fréquence F3 de la tension bobine $U_{BOB}$, le courant bobine $I_{BOB}$ présentant ici un profil en dents de scie, variant entre un seuil bas $I_1$, strictement supérieur au courant de décrochage $I_S$, et un seuil haut $I_2$, supérieur au seuil bas $I_1$. Le seuil bas $I_1$ est par exemple choisi supérieur de 5% du courant de décrochage $I_S$. Le seuil haut $I_2$ dépend notamment des caractéristiques de la bobine 32, telles que la résistance bobine $R_{BOB}$ et l'inductance bobine $L_{BOB}$.

**[0066]** La nature périodique du courant bobine $I_{BOB}$ engendre des vibrations mécaniques de l'actionneur électromagnétique 30. Pour éviter que ces vibrations ne génèrent un bruit perceptible par l'oreille humaine, la fréquence F3 est avantageusement choisie inférieure à 100 Hz, ou supérieure à 25 kHz. Dans l'exemple illustré, la fréquence F3 est de 100 Hz.

**[0067]** La phase P4 d'ouverture commence lorsque le dispositif électronique de contrôle 40 reçoit un ordre d'ouverture, à un instant $t_2$.

**[0068]** Le dispositif électronique de contrôle 40 commande l'ouverture de l'actionneur électromagnétique 30, ce qui se fait ici par ouverture de l'interrupteur d'alimentation T2 et l'ouverture de l'interrupteur de retombée T1 de manière à faire chuter la tension aux bornes de la bobine 32. Le courant bobine $I_{BOB}$ circule alors au travers de la diode de roue libre Drl, de la bobine 32, du dispositif de retombée Dz et de la résistance de shunt Rsh. Le circuit de commande 51 est alors dans un mode dit « de retombée », dans lequel le courant bobine $I_{BOB}$ décroit plus vite que dans le mode roue libre.

**[0069]** Lorsque le courant bobine $I_{BOB}$ passe en-deçà du courant de décrochage $I_S$, l'organe de rappel 36 et le mécanisme 290 repoussent les contacts mobiles 24 de leur position fermée vers leur position ouverte.

**[0070]** Une fois les phénomènes transitoires d'induction terminés, le courant bobine $I_{BOB}$ est nul, et le contacteur 1 est à nouveau à l'état ouvert de façon stable.

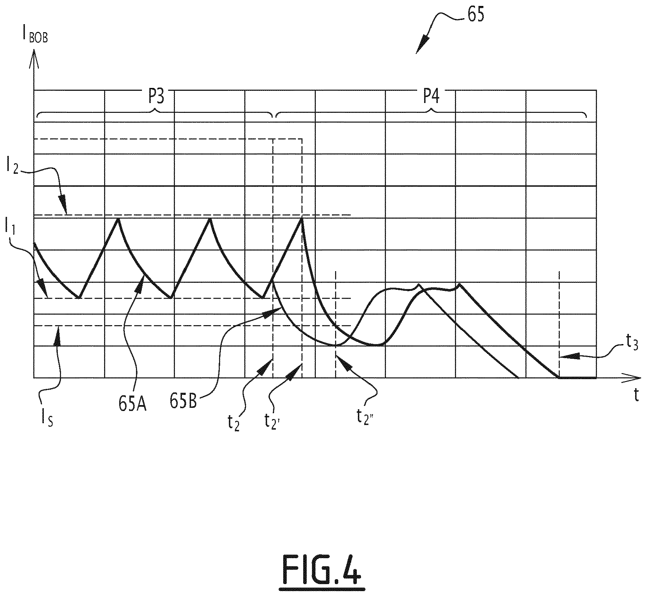

**[0071]** La figure 4 représente un graphique 65 illustrant l'évolution du courant bobine $I_{BOB}$ circulant dans la bobine 32 au cours du temps *t* lors du passage de la phase de maintien P3 à la phase d'ouverture P4. Une courbe 65A, en trait épais, représente l'évolution du courant bobine $I_{BOB}$ lorsque le dispositif électronique de contrôle 40 commande l'ouverture du contacteur 1 selon une stratégie d'ouverture avantageuse, détaillée ci-après. Une courbe 65B, en trait fin, représente l'évolution du courant bobine $I_{BOB}$ lorsque le dispositif électronique de contrôle 40 commande l'ouverture du contacteur 1 sans stratégie particulière, comme c'est le cas dans l'état de la technique.

**[0072]** Comme expliqué précédemment, pendant la phase de maintien P2 le courant bobine $I_{BOB}$ varie de manière périodique entre les seuils bas $I_1$ et haut $I_2$. Les courbes 64A et 65B sont superposées pendant la phase de maintien P3.

**[0073]** Dans l'état de la technique, lorsqu'un ordre d'ouverture est reçu à l'instant $t_2$, le dispositif de contrôle 40 commande immédiatement l'ouverture des interrupteurs T1 et T2. Le courant bobine $I_{BOB}$ commence à décroitre immédiatement, cette situation correspondant à la courbe 65B.

**[0074]** Avantageusement, dans le cadre de la présente invention, le dispositif de contrôle 40 commande l'ouverture du contacteur 1 lorsque le courant bobine $I_{BOB}$ est le plus élevé possible. Par « le plus élevé possible », on entend ici que le courant $I_{BOB}$ est supérieur ou égal à 80% du seuil haut $I_2$, de préférence supérieur à 95%, de préférence encore supérieur à 98%.

**[0075]** L'instant où le dispositif électronique de contrôle 40 commande l'ouverture du contacteur 1 définit un instant $t_2$', qui est postérieur à l'instant $t_2$.

**[0076]** Pour ne pas retarder exagérément l'instant $t_2$', le dispositif électronique de contrôle 40 commande l'ouverture de l'actionneur électromagnétique 30 au plus tard au bout d'une durée prédéfinie après avoir reçu l'ordre d'ouverture, la durée prédéfinie étant égale à une période de la tension bobine $U_{BOB}$. Autrement dit, le dispositif électronique de contrôle 40 commande l'ouverture de l'actionneur électromagnétique 30 de préférence au premier pic de seuil haut $I_2$ survenant après réception de l'ordre d'ouverture à l'instant $t_2$.

**[0077]** Dans l'exemple illustré, au cours de la phase de maintien P3 le courant bobine $I_{BOB}$ varie selon une fréquence F3 de 100 Hz. L'intervalle de temps entre deux pics de seuil haut $I_2$ est donc égal à 10 ms. Ainsi le décalage entre les instants $t_2$ et $t_2$' est au plus de 10 ms, ce qui correspond à une demi-période d'un courant d'alimentation à 50 Hz. Un tel décalage est acceptable compte tenu des contraintes de fonctionnement du contacteur 1.

**[0078]** On définit aussi un instant $t_2$" « de décrochage » comme étant un instant où le courant bobine $I_{BOB}$ passe, pour la première fois après l'instant $t_2$', en deçà du courant de décrochage $I_S$. On définit enfin un instant $t_3$ comme étant un instant où le courant bobine $I_{BOB}$ s'annule de manière stable. Ainsi le noyau 34 est encore immobile entre les instants $t_2$' et $t_2$" et commence à bouger après l'instant $t_2$".

**[0079]** On s'intéresse à présent aux grandeurs électriques et électromagnétiques de la bobine 32.

Un flux magnétique $\phi$ est généré lorsque le courant bobine $I_{BOB}$ circule dans la bobine 32. La valeur du flux magnétique $\phi$ dépend notamment de la valeur du courant bobine $I_{BOB}$ et de la position du noyau mobile 34.

Par exemple, la valeur du flux magnétique $\phi$ est liée aux valeurs de tension bobine $U_{BOB}$ et de courant bobine $I_{BOB}$ selon l'équation suivante, notée Math 1 dans ce qui suit :

$$U_{BOB} = R_{BOB} \cdot I_{BOB} + N \frac{d\phi}{dt} \qquad [Math\ 1]$$

dans laquelle N est le nombre de spires de la bobine 32, et $\phi$ est le flux magnétique traversant chaque spire de la bobine 32.

On définit une position $x$ comme une position du noyau mobile 34 par rapport à la bobine 32. Dans de nombreux modes de réalisation, le noyau mobile 34 peut se déplacer en translation par rapport à la bobine 32 le long d'un axe de déplacement. La position $x$ est alors définie le long de cet axe de déplacement. Par convention, la position $x$ est nulle lorsque le contacteur 1 est à l'état ouvert. Pour chacune des phases électriques du contacteur 1, la position des contacts mobiles 24 est ainsi reliée à la position $x$. Par extension, la position $x$ représente aussi une position de l'actionneur électromagnétique 30 ou du contacteur 1.

En dérivant $\phi$ dans l'équation Math 1, on obtient une équation générale Math 2 régissant les grandeurs électromagnétiques dans l'actionneur 1 :

$$U_{BOB} = R_{BOB} \cdot I_{BOB} + N \frac{d\phi}{dI_{BOB}} \frac{dI_{BOB}}{dt} + N \frac{d\phi}{dx} \frac{dx}{dt} + N \frac{d\phi}{di_f} \frac{di_f}{dt} \quad [Math\ 2]$$

dans laquelle le dernier terme $N \dfrac{d\phi}{di_f} \dfrac{di_f}{dt}$ fait intervenir des courants d'induction, aussi dits courants de Foucault, notés $i_f$.

Dans le cadre de la présente invention, le contacteur 1 présente une structure limitant la génération de courants d'induction $i_f$, ce qui permet de négliger le dernier terme de l'équation Math 2. Selon des exemples non limitatifs, le contacteur 1 présente une structure en tôle feuilletée, réalisée par empilage de tôles découpées et présentant une conductivité très faible dans l'axe d'empilement des tôles, notamment du fait des discontinuités en bord de tôle. La faible conductivité globale résultante est la cause du peu de courant induits générés par ce type de contacteur 1.

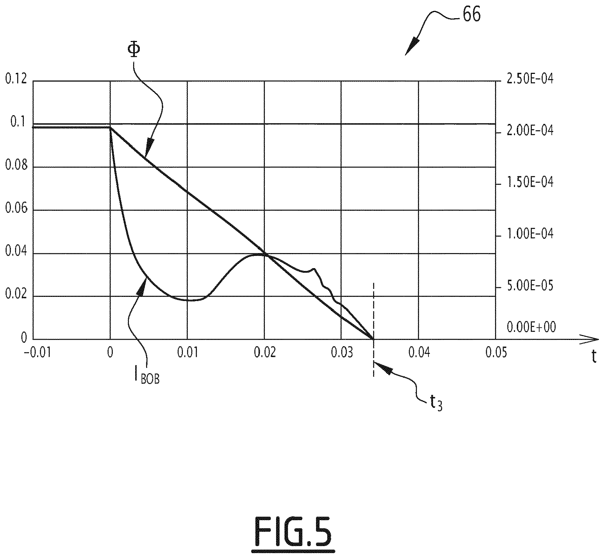

Une illustration de cet effet de réduction des courants induits $i_f$ est représentée sur la figure 5, qui représente un graphique 66 illustrant l'évolution du courant bobine $I_{BOB}$ et du flux magnétique $\phi$ au cours d'une phase d'ouverture du contacteur 1. On constate l'absence de courants induits $i_f$ par l'absence de déphasage entre le flux magnétique $\phi$ et le courant bobine $I_{BOB}$, qui atteignent chacun une valeur nulle au même instant $t_3$.

Les courants induits étant négligés, le circuit magnétique présente une reluctance *Rel* qui est, d'une part, fonction de la position $x$ du noyau mobile 34 et du courant bobine $I_{BOB}$, et qui est, d'autre part, liée au flux magnétique $\phi$ et au courant bobine $I_{BOB}$ par la relation suivante $Rel(x, I_{BOB}) \cdot \phi = N \cdot I_{BOB}$.

Autrement dit, le flux magnétique $\phi$ est une fonction de la position $x$ et du courant bobine $I_{BOB}$, le flux magnétique $\phi$ pouvant être exprimé sous la forme d'une relation analytique, ou bien, pour une meilleure précision, par une surface de réponse bidimensionnelle générée par des outils de simulation du circuit magnétique du contacteur 1.

Dans la grande majorité des cas, la surface $\phi = f(x, I_{BOB})$ présente un caractère bijectif, c'est-à-dire que pour un courant bobine $I_{BOB}$ donnée, à une valeur donnée de la position $x$ correspond une unique valeur de flux magnétique $\phi$. Ceci permet de reconstruire une fonction inverse $x = g(\phi, I_{BOS})$ donnant la valeur de la position $x$ en fonction du flux magnétique $\phi$ et du courant bobine $I_{BOB}$.

La surface $\phi = f(x, I_{BOB})$, ou bien sa fonction inverse $x = g(\phi, I_{BOB})$, est enregistrée dans la mémoire du dispositif électronique de contrôle 40, par exemple sous la forme d'une table de données caractéristique de l'actionneur électromagnétique 30, la table de données définissant une relation bijective entre la position $x$ du noyau 34, le flux bobine $\phi$ et le courant bobine $I_{BOB}$.

Le flux magnétique $\phi$ est aussi donné par intégration temporelle de l'équation Math 1. On obtient alors l'équation Math 3 ci-dessous :

$$\phi(t) = \int \frac{U_{BOB} - R_{BOB} \cdot I_{BOB}}{N} \cdot dt + \phi_0 \quad [Math\ 3]$$

dans laquelle $U_{BOB}$ et $I_{BOB}$ sont mesurés, N, $dt$ et $R_{BOB}$ sont connus et $\phi_0$ est une valeur initiale du flux magnétique $\phi$, au début de l'intervalle d'intégration. Dans le cadre de la présente invention, l'intervalle d'intégration commence de préférence au moment où le dispositif électronique de commande 40 commande l'ouverture de l'actionneur magnétique 30, c'est-à-dire à l'instant $t_2$'.

Le flux magnétique $\phi$ peut être calculé à partir de l'équation Math 3 selon des méthodes de calcul numérique mises en oeuvre par le dispositif électronique de contrôle 40.

Plus l'intervalle temporel d'intégration $dt$ est petit, autrement dit plus le pas d'intégration est court, et plus réduite est l'erreur de calcul. L'intervalle $dt$ est par exemple proportionnel à l'inverse d'une fréquence d'horloge de l'unité logique de calcul du dispositif électronique de contrôle 40. Selon des exemples, la fréquence d'horloge du dispositif 40 est de 1 kHz.

Afin de calculer le flux $\phi$ par intégration des mesures de $U_{BOB}$ et $I_{BOB}$ et de remonter, à l'aide de la fonction inverse $x = g(\phi, I_{BOB})$, à l'évolution de la position $x$ du noyau mobile 34, il convient de déterminer le flux initial $\phi_0$. On définit une estimée du flux initial $\hat{\phi}_0$.

Une première méthode consiste à déterminer la valeur de $\hat{\phi}_0$ à partir de la surface de réponse $\phi = f(x, I_{BOB})$ connue, en estimant une valeur initiale de la position $x$, notée estimée $\hat{x}_0$. L'estimée $\hat{x}_0$ peut être calculée par exemple via l'inductance bobine $L_{BOB}$, connue, le courant bobine $I_{BOB}$ étant mesuré. On a alors $\hat{\phi}_0 = f(\hat{x}_0, I)$. En variante, le noyau 34 étant en butée en position fermée, l'estimé $\hat{x}_0$ peut être évaluée d'après la géométrie de l'actionneur 30.

Cependant, une telle première méthode de détermination de la valeur estimée $\hat{x}_0$ de la position est relativement grossière et ne permet notamment pas de tenir compte de la variabilité des entrefers magnétiques. Par exemple, un matage des surfaces ou une pollution de l'entrefer peut entrainer une variation de la position estimée $\hat{x}_0$ considérée comme fermée, ce qui entraine une erreur sur l'estimée de flux initial $\hat{\phi}_0$ et donc sur la reconstruction de la position $x$ au cours de la phase d'ouverture.

Une deuxième méthode, dite méthode d'autocorrection, repose sur le fait que le noyau mobile 34 reste immobile en position fermée au cours de la phase d'ouverture P4 tant que le courant bobine $I_{BOB}$ est supérieur au courant de décrochage $I_S$, c'est-à-dire avant l'instant $t_2$'' de décrochage, tant que le noyau 34 est immobile en position fermée.

Autrement dit, à chaque instant $t$ compris entre $t_2$' et $t_2$'', tant que le courant bobine $I_{BOB}$ est supérieur au courant de décrochage $I_S$, lorsque le flux magnétique $\phi$ est calculé à l'aide de l'équation Math 3 et que la position $x$ à l'instant $t$ en est déduite à l'aide de la fonction inverse $x = g(\phi, I_{BOB})$, si la position calculée n'est pas constante, autrement dit $x(t) \neq x(t_2')$, c'est qu'il y a une erreur sur l'estimée de flux initial $\hat{\phi}_0$. Le flux magnétique $\phi$ à l'instant test alors compensé pour corriger cette erreur, cette compensation se traduisant par une ré-estimation du flux initial $\hat{\phi}_0$. La correction du flux $\phi$ est appliquée plusieurs fois, au cours de plusieurs calculs successifs et tant que l'instant $t$ compris entre $t_2$' et $t_2$'', jusqu'à convergence de l'estimée de flux initial $\hat{\phi}_0$ et du flux réel $\phi_0$. En résultat de la méthode d'autocorrection, l'erreur sur le flux initial $\phi_0$ est compensée de manière précise.

Ainsi, lorsque le courant bobine $I_{BOB}$ décroît en deçà du courant de décrochage $I_S$ et que le noyau 34 commence à bouger, la connaissance précise du flux magnétique $\phi$ permet à son tour de calculer la position $x$ de manière précise.

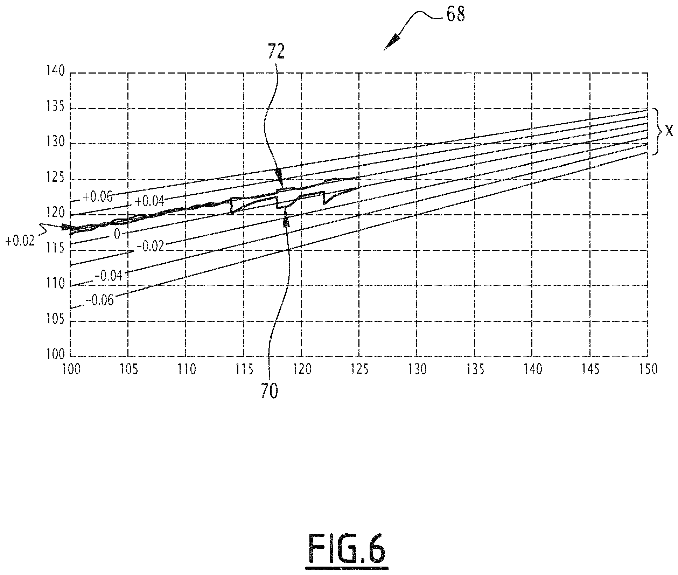

La figure 6 représente un graphique 68 illustrant un exemple de mise en oeuvre de la méthode d'autocorrection. Sur ce graphique 68, la courbe 70 représente le flux magnétique $\phi$ calculé avec autocorrection, en fonction du courant bobine $I_{BOB}$ multiplié par le nombre de spire de la bobine 32, alors que la position $x$ initiale est fixe et que l'estimée du flux initial $\hat{\phi}_0$ est erronée. Dans l'exemple, on a une position initiale estimée $\hat{x}_0 = 0$ mm, alors que le flux initial $\phi_0$ est le flux magnétique correspondant à une position x = +0,02 mm. On observe des divergences du flux magnétique $\phi$ par rapport à une caractéristique correspondant à une position $x$ fixe, amenant une série d'autocorrections jusqu'à convergence du flux estimé et du flux réel $\phi$. La convergence du flux estimé se traduit par une position $x$ calculée stable, qui correspond à la position $x$ réelle.

La courbe 72 représente le flux magnétique $\phi$ calculé avec autocorrection, sans erreur sur le flux initial $\phi_0$. Dans l'exemple, on a une position initiale estimée $\hat{x}_0 = +0,02$ mm, et le flux initial $\hat{\phi}_0$ est le flux magnétique correspondant à cette position x = +0,02 mm. Le flux calculé suit bien une caractéristique de position fixe et ne nécessite pas de correction.

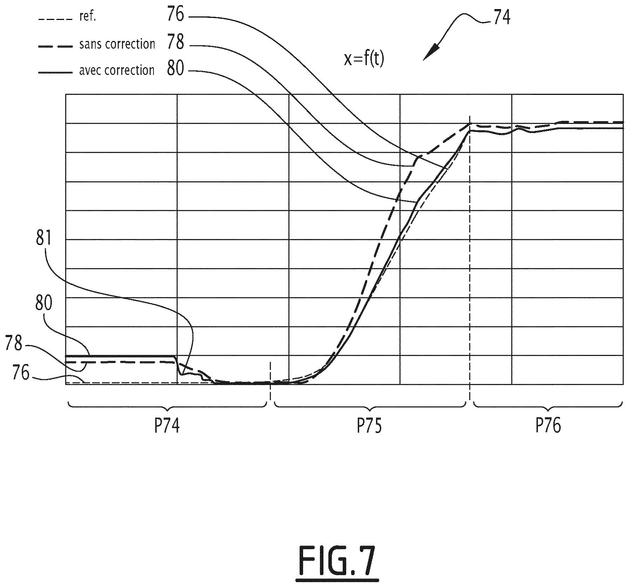

La figure 7 représente un graphique 74 illustrant l'effet de la méthode d'autocorrection pour la détermination de la position x. Une courbe 76, en pointillés, représente l'évolution de la position $x$, la position $x$ étant mesurée directement à l'aide d'un capteur de position du noyau mobile 34 à des fins de comparaison avec les résultats de la méthode décrite ci-dessus. On comprend qu'en pratique, le contacteur 1 est normalement dépourvu d'un tel capteur de position.

Au cours d'une phase initiale P74, la position $x$ mesurée reste constante. Au cours d'une phase P75, postérieure à la phase initiale P74, le noyau 34 se déplace de sa position fermée vers sa position ouverte, et la position $x$ évolue. Au cours d'une phase P76, postérieure à la phase P75, le noyau 34 est en position d'ouverture stable, et la position $x$ est à nouveau constante.

Une courbe 78, en gros pointillés, représente l'évolution de la position x, calculée conformément à la méthode décrite ci-dessus, sans autocorrection. Le flux initial estimé $\hat{\phi}_0$ est erroné sans être corrigé.

Une courbe 80 représente l'évolution de la position de la position $x$ au cours d'une phase de fermeture, calculée conformément à la méthode décrite ci-dessus, avec autocorrection, alors que les conditions initiales sont identiques à celles du calcul de la courbe 78. Le flux initial estimé $\hat{\phi}_0$ est erroné, mais est corrigé.

Au cours d'une phase initiale P74, la position $x$ reste constante. La courbe 78 présente des décrochements 81 en marche d'escalier, qui résultent de la mise en oeuvre de la procédure d'autocorrection. Par ailleurs, la courbe 78 rejoint la courbe 76 malgré l'incertitude portant sur le flux initial $\phi_0$. En résultat, au cours des phases P75 et P76, la courbe 80 adhère plus à la courbe 76 que la courbe 78, ce qui montre l'effet positif de la méthode d'autocorrection. Il n'est pas nécessaire d'installer un capteur de position pour remonter de façon fiable à l'évolution de la position $x$ en fonction du temps au cours de la phase de fermeture P2. La méthode d'autocorrection est avantageusement mise en oeuvre dans tous les cas.

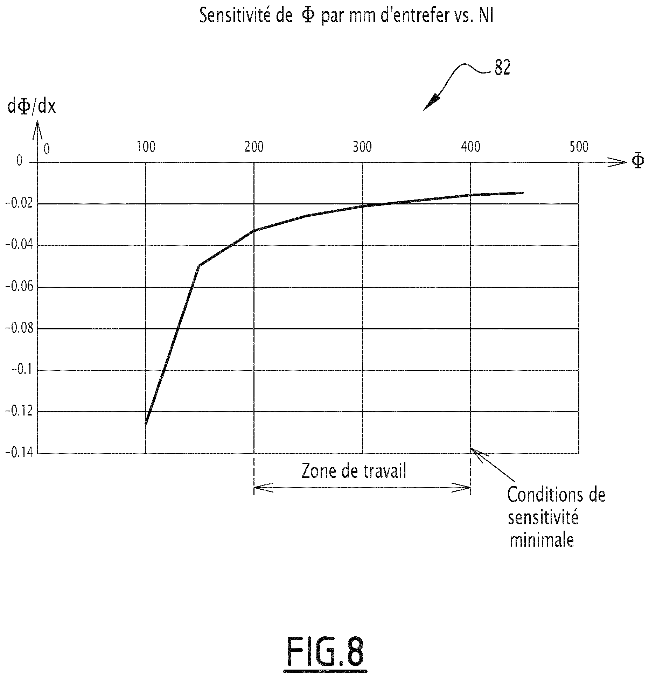

La caractéristique non linéaire des matériaux ferromagnétiques fait que le flux magnétique $\phi$ est moins sensible aux variations d'entrefer lorsque le circuit magnétique, en particulier la bobine 32, est saturé. Ce phénomène est illustré sur la figure 8, qui représente un graphe 82, illustrant la sensibilité du flux magnétique par mm d'entrefer $\frac{d\phi}{dx}$ , en fonction du flux magnétique $\phi$, égal au courant bobine $I_{BOB}$ multiplié par le nombre de spires N. Ainsi, plus le courant bobine $I_{BOB}$ est élevé, et moindre est la sensibilité du flux magnétique $\phi$ en fonction de l'entrefer, autrement dit en fonction de la position $x$.

Pour cette raison, après avoir reçu l'ordre d'ouverture, le dispositif électronique de contrôle 40 commande l'ouverture de l'actionneur électromagnétique 30 lorsque le courant bobine $I_{BOB}$ est le plus élevé possible, c'est-à-dire supérieur ou égal à 80% du seuil haut $I_2$, de préférence supérieur à 95%, de préférence encore supérieur à 98% du seuil haut $I_2$. Ceci permet à la fois de saturer le circuit magnétique et de laisser plus de temps pour mettre en oeuvre la méthode d'autocorrection.

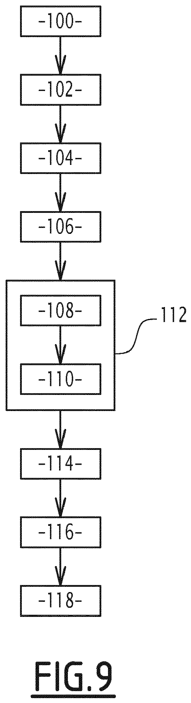

Un exemple de fonctionnement d'un procédé d'estimation de propriétés du contacteur 1 selon un mode de réalisation préféré est maintenant décrit en référence à la figure 9. Cependant, en variante, les étapes de ce procédé pourraient être exécutées dans un ordre différent. Certaines étapes pourraient être omises. L'exemple décrit ne fait pas obstacle à ce que, dans d'autres modes de réalisation, d'autres étapes soient mises en oeuvre conjointement et/ou séquentiellement avec les étapes décrites.

Au cours d'une étape 100, le procédé est initialisé, alors que le contacteur 1 est initialement dans un état fermé stable, par exemple au cours de la phase de maintien P3. Le dispositif électronique de contrôle 40 est en attente d'un ordre d'ouverture du contacteur 1.

Ensuite, au cours d'une étape 102, le dispositif électronique de contrôle 40 reçoit un ordre d'ouverture du contacteur 1. L'instant $t_2$ de réception de l'ordre d'ouverture est le début de la phase d'ouverture P4.

Ensuite, au cours d'une étape 104, le dispositif électronique de contrôle 40 commande, à l'instant $t_2$', l'ouverture de l'actionneur électromagnétique 30. La commande d'ouverture se fait ici en annulant la tension de commande aux bornes de la bobine 32.

De préférence, le dispositif électronique de contrôle 40 commande l'ouverture de l'actionneur électromagnétique 30 lorsque le courant bobine $I_{BOB}$ est supérieur ou égal à 80% du seuil haut $I_2$, de préférence supérieur à 95%, de préférence encore supérieur à 98%.

Pendant la phase de maintien P3 et jusqu'à l'instant $t_2$', la tension bobine $U_{BOB}$ varie de manière périodique à une fréquence F3, ici égale à 100 Hz, autrement dit la variation périodique de la tension bobine définit une période égale à 1/F3, soit ici 10 ms.

Avantageusement, le dispositif électronique de contrôle 40 commande l'ouverture de l'actionneur électromagnétique 30 au plus tard au bout d'une durée prédéfinie après avoir reçu l'ordre d'ouverture. Selon des exemples, la durée prédéfinie est égale à une période de la tension bobine $U_{BOB}$, soit ici 10 ms.

Ensuite, au cours d'une étape 106 ; le dispositif électronique de contrôle 40 mesure et enregistre le courant bobine $I_{BOB}$ et la tension bobine $U_{BOB}$, par exemple jusqu'à ce que le contacteur 1 soit en position ouverte, ou bien pendant une durée d'enregistrement prédéfinie, enregistrée dans le dispositif électronique de contrôle. Cette durée d'enregistrement est par exemple égale à cinq périodes d'un courant d'alimentation à 50 Hz, soit 100 ms.

Ensuite, le procédé comprend une étape 112, de calcul et d'enregistrement du flux magnétique $\phi$ traversant la bobine 32.

L'étape 112 comprend une sous-étape 110, dans laquelle le flux magnétique $\phi$ est calculé par intégration des valeurs enregistrées du courant bobine $I_{BOB}$, de la tension bobine $U_{BOB}$ et des valeurs, préalablement enregistrées dans le dispositif électronique de contrôle 40, de résistance $R_{BOB}$ et d'inductance bobine $L_{BOB}$.

L'étape 112 comprend avantageusement une sous-étape initiale 108 d'autocorrection, antérieure à la sous-étape 110, consistant à, tant que le courant bobine $I_{BOB}$ est supérieur au seuil bas $I_1$ et que le noyau 34 est encore en position de fermeture, estimer une valeur du flux initial $\phi_0$, le calcul par intégration du flux magnétique $\phi$ à la sous-étape 110 tenant compte de la valeur du flux initial $\phi_0$ calculée à la sous-étape d'autocorrection 108.

Selon des exemples, la sous-étape 108 d'autocorrection dure de l'instant $t_2$'jusqu'à l'instant $t_2''$ de décrochage, tandis que la sous-étape 110 commence à l'instant $t_2''$.

Ensuite, le procédé comprend une étape 114, consistant à évaluer et enregistrer la position $x$ du contacteur 1, d'une part à partir des valeurs enregistrées du flux magnétique $\phi$ et du courant bobine $I_{BOB}$ et, d'autre part, en fonction d'une table de données caractéristique de l'actionneur électromagnétique 30, la table de données étant préalablement enregistrée dans le dispositif électronique de contrôle 40 et définissant une relation bijective entre la position $x$ du noyau 34, le flux magnétique $\phi$ et le courant bobine $I_{BOB}$.

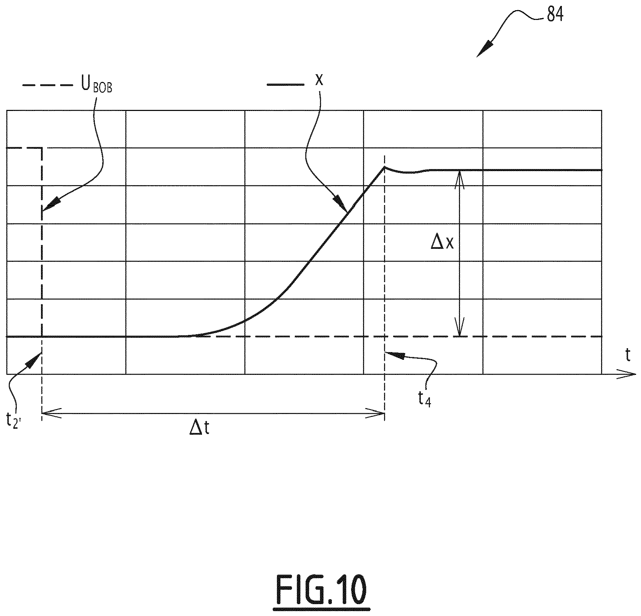

La figure 10 représente un graphique 84 illustrant l'évolution de la position $x$ et de la tension bobine $U_{BOB}$ au cours d'une phase d'ouverture P4. On définit un instant $t_4$ comme étant un instant où le noyau mobile 34 est en position ouverte de manière stable. On définit aussi une course $\Delta x$ du noyau mobile 34 comme étant égale à une différence entre les positions $x$ aux instants $t_2'$ et $t_4$, c'est-à-dire la différence de position x entre la position ouverte et la position fermée.

On définit aussi un temps de retombée $\Delta t$, comme étant égal au temps écoulé entre l'instant $t_2'$, où le dispositif électronique de contrôle 40 commande l'ouverture de l'actionneur électromagnétique 30, et l'instant $t_4$, où l'actionneur électromagnétique 30 est en position ouverte de manière stable.

La connaissance de la position $x$ permet de tirer diverses informations sur l'état du contacteur 1.

Selon un premier exemple, le procédé est configuré pour comparer la course $\Delta x$ du noyau mobile 34 à une valeur de référence enregistrée dans le dispositif électronique de contrôle 40, afin de détecter d'éventuels défauts d'ordre mécanique.

Selon un autre exemple, le procédé est configuré pour vérifier l'absence de frottements ou de blocages d'origine mécaniques en comparant le temps de retombée $\Delta t$ à un temps de référence enregistré dans le dispositif électronique de contrôle 40.

Au cours d'une étape 116 du procédé, un profil de vitesse de déplacement du contacteur 1 et un profil d'accélération $a$ du contacteur 1 sont calculés par dérivation temporelle des valeurs de position $x$ enregistrées au cours de l'étape 114. Les profils de vitesse $v$ et d'accélération $a$ sont enregistrés dans le dispositif électronique de contrôle 40. Par extension, les profils de vitesse $v$ et d'accélération $a$ du contacteur 1 sont aussi les profils de vitesse $v$ et d'accélération $a$ de l'actionneur électromagnétique 30 ou du noyau mobile 34.

Ensuite, au cours d'une étape 118, le dispositif électronique de contrôle 40 est configuré pour calculer une vitesse dite « de séparation », égale à une vitesse $v$ du contacteur 1 lorsque la position x du contacteur 1 atteint une position dite « d'écrasement maximal », notée Emax et dite « *max overtravel* » en anglais, correspondant à un déplacement du noyau 34, de la position fermée vers la position ouverte. En pratique, ce déplacement dépend de la géométrie de l'actionneur 30 et est généralement compris entre 0,5 mm et 3 mm, par exemple égal à 2 mm. De préférence le dispositif électronique de contrôle 40 est configuré pour émettre une alerte si la vitesse de séparation est inférieure à un seuil préalablement enregistré dans le dispositif électronique de contrôle 40.

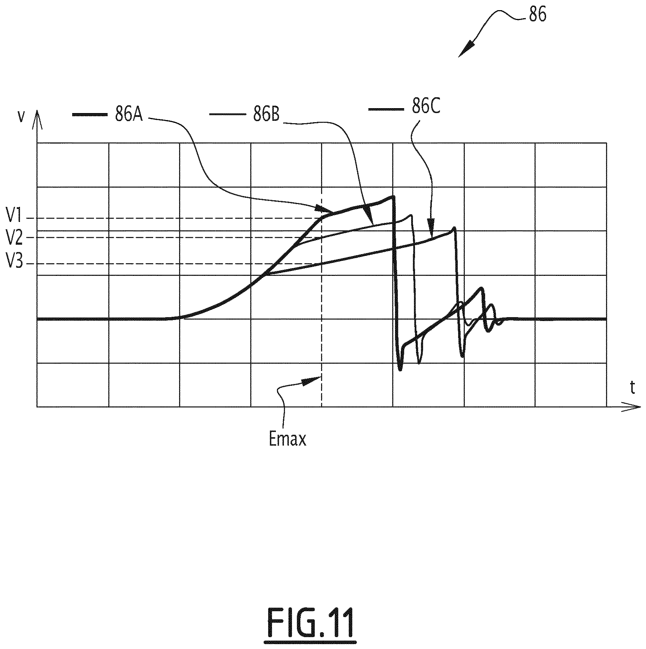

La figure 11 représente un graphe 86 illustrant, au cours d'une phase d'ouverture P4, trois profils de vitesse 86A, 86B et 86C, correspondant au profil de vitesse $v$ du noyau 34 de trois contacteurs 1 de modèle identique mais présentant des états d'usure différents, respectivement neuf, légèrement usé et usé.

On définit une vitesse de séparation V1, respectivement V2 et V3, comme étant la vitesse de séparation du noyau 34 du contacteur 1 neuf, respectivement légèrement usé et usé.

L'effet de l'usure du contacteur sur la vitesse de séparation est observable en comparant les vitesses de séparation V1, V2 et V3. Plus le contacteur 1 est usé, et plus la vitesse de séparation est réduite. Il est ainsi possible de définir un seuil minimal de vitesse de séparation, en deçà duquel le dispositif électronique de contrôle 40 émet une alerte pour signaler à un utilisateur qu'une maintenance doit être programmée.

Pour un contacteur 1 en bon état, à partir de l'instant de décrochage $t_2''$, les efforts magnétiques sont toujours inférieurs aux efforts de l'organe de rappel 36, ce qui se traduit par une vitesse $v$ strictement croissante jusqu'à ce que le noyau 34 arrive en butée de fin de course en position ouverte. Dans le cas d'un contacteur 1 usé, en particulier lorsque les pastilles de contact 29 sont usées et que la surface des pastilles de contact 29 est endommagée, des microsoudures se forment entre les pastilles 29 des contacts mobiles 24 et fixes 28 au cours de la phase de maintien P3. Lors de l'ouverture du contacteur 1, la rupture des microsoudures ralentit le mouvement du noyau mobile 34, et la vitesse $v$ présente une portion décroissante avant que le noyau 34 n'arrive en butée en position ouverte.

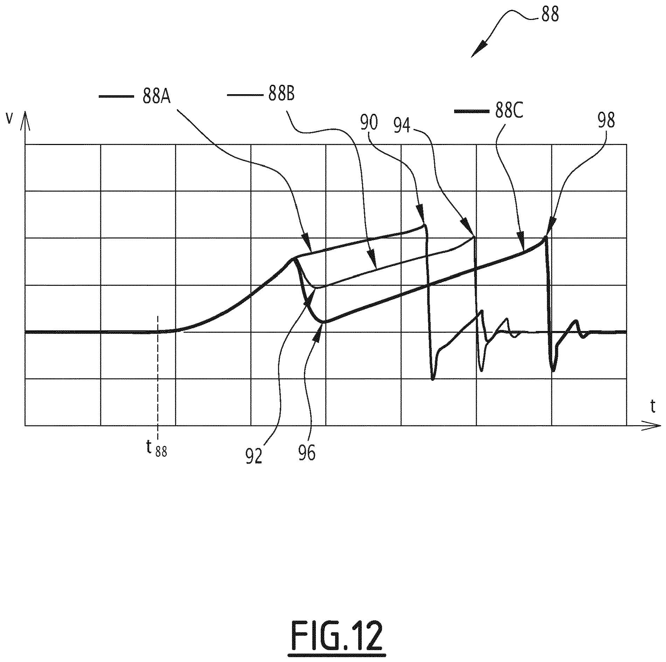

La figure 12 représente un graphe 88 illustrant, au cours d'une phase d'ouverture, trois profils de vitesse 88A, 88B et 88C, correspondant aux vitesses $v$ des noyaux 34 de trois contacteurs 1 de modèle identique mais présentant des états de microsoudures différents, respectivement sans microsoudure - *healthy product* en anglais -, avec de légères microsoudures - *light uweld* en anglais - et avec d'importantes microsoudures - *strong uweld en* anglais -. Les trois profils de vitesse 88A, 88B et 88C sont synchronisés, c'est-à-dire que le mouvement débute à un même instant $t_{88}$. Autrement dit les vitesses sont nulles jusqu'à l'instant $t_{88}$.

Le profil 88A, correspondant au contacteur 1 sans microsoudure, est croissant de manière monotone depuis l'instant $t_{88}$ jusqu'à un pic 90 d'arrivée en butée du noyau 34.

Le profil 88B, correspondant au contacteur 1 avec de légères microsoudures, présente un pic 94 d'arrivée en butée du noyau 34. Cependant le profil 88B n'est pas croissant de manière monotone depuis l'instant $t_{88}$ jusqu'au pic 94 mais présente, entre l'instant $t_{88}$ et le pic 94, une portion décroissante, suivie à nouveau d'une portion croissante. Une jonction entre les portions décroissante et croissante présente une tangente horizontale et définit un minimum local 92 du profil 88B. Autrement dit, le profil de vitesse 88B présente un minimum local 92 entre l'instant $t_{88}$ du début du mouvement et un pic 94 d'arrivée en butée du noyau 34.

Le profil 88C, correspondant au contacteur 1 avec d'importantes microsoudures, présente un minimum local 96 entre l'instant $t_{88}$ du début du mouvement et un pic 98 d'arrivée en butée du noyau 34, le minimum local 96 étant plus marqué que le minimum local 92 du profil 88B. Autrement dit, plus les microsoudures sont importantes, et plus la vitesse $v$ présente un minimum local marqué entre l'instant $t_{88}$ du début du mouvement du noyau 34 et l'arrivée en butée du noyau 34 en position d'ouverture.

Plus généralement, le procédé de diagnostic selon l'invention permet de remonter de façon précise au profil de position $x$ du noyau mobile 34 en fonction du temps, ainsi qu'aux profils de vitesse $v$ et d'accélération $a$ dérivés du profil de position $x$. Ces informations peuvent être combinées de multiples manières pour surveiller l'usure de composants spécifiques du contacteur 1, par exemple les pastilles de contact 29, ou bien le mécanisme de l'actionneur électromagnétique 30.

Dans l'exemple illustré, le dispositif électronique de contrôle 40 remplit à la fois les fonctions de pilotage du dispositif de fermeture 30 et de mise en oeuvre du procédé de diagnostic selon l'invention.

En variante non représentée, le procédé de diagnostic est mis en oeuvre par un dispositif électronique spécifique, qui est rajouté à un contacteur existant lors d'une opération de maintenance. Un tel dispositif spécifique n'a besoin, pour mettre en oeuvre le procédé de diagnostic selon l'invention, que des mesures du courant bobine $I_{BOB}$, de tension bobine $U_{BOB}$.

Selon une autre variante, lorsqu'un contacteur 1 comprend un dispositif électronique de contrôle 40 qui n'est pas configuré pour mettre en oeuvre le procédé de diagnostic selon l'invention, si les capteurs de courant bobine et de tension bobine sont présents, il est possible de configurer le dispositif électronique de contrôle 40 du contacteur 1 pour qu'il puisse mettre en oeuvre le procédé de diagnostic selon l'invention, par exemple en remplaçant physiquement le dispositif électronique de contrôle 40 ou bien, le cas échéant, en changeant le code informatique du dispositif électronique de contrôle 40.

Les modes de réalisation et les variantes mentionnées ci-dessus peuvent être combinés entre eux pour générer de nouveaux modes de réalisation de l'invention.

**Revendications**

1. Procédé de diagnostic d'un état de fonctionnement d'un appareil de commutation (1), configuré pour être couplé à un conducteur électrique (20) et comprenant :

   - des contacts séparables (24, 28) associés au conducteur électrique et pilotés par un actionneur électromagnétique (30) comprenant une bobine (32) reliée à un dispositif électronique de contrôle (40), qui est configuré pour appliquer une tension bobine ($U_{BOB}$) de commande aux bornes de la bobine,
   - des capteurs (Rsh, 50) configurés pour mesurer la tension bobine ($U_{BOB}$) et une intensité d'un courant bobine ($I_{BOB}$) circulant dans la bobine,
   dans lequel le procédé comprend les étapes consistant à :

   **a)** recevoir (102) un ordre d'ouverture de l'appareil de commutation, l'appareil de commutation étant initialement dans un état fermé, l'ordre d'ouverture étant reçu par le dispositif électronique de contrôle ;
   **b)** après avoir reçu l'ordre d'ouverture, commander (104) l'ouverture de l'actionneur électromagnétique (30) au moyen du dispositif électronique de contrôle (40) ;
   **c)** pendant la commutation de l'appareil de commutation (1) vers l'état ouvert, mesurer et enregistrer (106) les valeurs de tension bobine ($U_{BOB}$) et de courant bobine ($I_{BOB}$) ;
   **d)** calculer et enregistrer (112) des valeurs d'un flux magnétique ($\phi$) traversant la bobine (32), par intégration des valeurs enregistrées du courant bobine, de la tension bobine et des valeurs de résistance ($R_{BOB}$) et d'inductance ($L_{BOB}$) de la bobine, préalablement enregistrées dans le dispositif électronique de contrôle ;

   **caractérisé en ce que** le procédé comprend, en outre, l'étape consistant à :
   **e)** à partir des valeurs enregistrées de flux magnétique ($\phi$) et de courant bobine ($I_{BOB}$), évaluer et enregistrer (114) des positions ($x$) d'un noyau (34) de l'actionneur électromagnétique (30) en fonction d'une table de données caractéristique de l'actionneur électromagnétique, la table de données étant préalablement enregistrée dans le dispositif électronique de contrôle (40) et définissant une relation bijective entre la position ($x$) du noyau (34), le flux magnétique ($\phi$) et le courant bobine ($I_{BOB}$).

2. Procédé selon la revendication précédente, dans lequel l'étape (112) de calcul du flux magnétique ($\phi$) comprend

une sous-étape initiale (108) dite d'autocorrection, suivie d'une sous-étape (110) de calcul, la sous-étape d'autocorrection consistant à, tant que le courant bobine ($I_{BOB}$) est supérieur à un seuil bas ($I_1$), lui-même strictement supérieur à un courant dit « de décrochage » ($I_S$) en deçà duquel le noyau mobile (34) est repoussé en position ouverte par un organe de rappel (36) de l'actionneur électromagnétique (30), évaluer et enregistrer une valeur initiale du flux magnétique ($\phi$), dite « flux initial » ($\phi_0$), de manière que lorsque le courant bobine ($I_{BOB}$) décroit en deçà du courant de décrochage ($I_D$), le calcul par intégration du flux magnétique ($\phi$) au cours de la phase de calcul (110) tient compte de la valeur du flux initial ($\phi_0$).

3. Procédé selon la revendication précédente, dans lequel le dispositif électronique de contrôle (40) est configuré pour, lorsque l'appareil de commutation (1) est à l'état fermé, faire varier la tension bobine ($U_{BOB}$) de manière que le courant bobine ($I_{BOB}$) varie entre le seuil bas ($I_1$) et un seuil haut ($I_2$), strictement supérieur au seuil bas, et dans lequel après avoir reçu l'ordre d'ouverture, le dispositif électronique de contrôle commande l'ouverture de l'actionneur électromagnétique (30) lorsque le courant bobine ($I_{BOB}$) est supérieur ou égal à 80% du seuil haut ($I_2$), de préférence supérieur à 95%, de préférence encore supérieur à 98%.

4. Procédé selon la revendication précédente, dans lequel la variation de tension bobine ($U_{BOB}$) est faite de manière périodique, par exemple par hachage, le courant bobine ($I_{BOB}$) variant aussi de façon périodique entre les seuils bas ($I_1$) et haut ($I_2$), et dans lequel après avoir reçu l'ordre d'ouverture, le dispositif électronique de contrôle (40) commande l'ouverture de l'actionneur électromagnétique (30) au plus tard au bout d'une durée prédéfinie après avoir reçu l'ordre d'ouverture, la durée prédéfinie étant égale à une période de la tension bobine ($U_{BOB}$).

5. Procédé selon l'une quelconque des revendications précédentes, dans lequel le dispositif électronique de contrôle (40) est configuré pour calculer un temps dit « de retombée » ($\Delta t$), égal au temps écoulé entre l'instant où le dispositif électronique de contrôle commande l'ouverture de l'actionneur électromagnétique (30) et l'instant où l'actionneur électromagnétique est en position ouverte.

6. Procédé selon l'une quelconque des revendications précédentes, dans lequel le procédé comprend une étape (116) consistant à calculer, par dérivation temporelle des valeurs de position (x) de l'appareil de commutation (1) enregistrées dans le dispositif électronique de contrôle (40), un profil de vitesse (*v*) de déplacement de l'appareil de commutation et un profil d'accélération (*a*) de l'appareil de commutation, et à enregistrer les profils de vitesse et d'accélération de l'appareil de commutation dans le dispositif électronique de contrôle (40).

7. Procédé selon la revendication précédente, dans lequel le procédé comprend une étape (118) consistant à calculer une valeur de vitesse dite « de séparation » (V1, V2, V3), égale à une vitesse (*v*) de déplacement du noyau (34) lorsque le noyau est dans une position dite « d'écrasement maximal » correspondant à un déplacement du noyau de sa position fermée vers sa position ouverte, sensiblement égal à 2 mm.

8. Procédé selon l'une quelconque des revendications 6 ou 7, dans lequel le procédé comprend une étape (118) consistant à détecter, au cours de la phase d'ouverture de l'appareil de commutation (1), un minimum local (92, 96) de la vitesse (*v*) du noyau (34) entre le début du mouvement du noyau et le moment où le noyau arrive en butée en position ouverte.

9. Appareil de commutation électrique (1) pour la mise en oeuvre d'un procédé de diagnostic conforme à l'une quelconque des revendications 1 à 8, l'appareil de commutation comprenant :

   - des contacts séparables (24, 28), déplacés entre une position ouverte et une position fermée par un actionneur électromagnétique (30) comprenant une bobine (32) et un noyau mobile (34) lié aux contacts séparables, l'appareil de commutation présentant une structure limitant la génération de courants d'induction ;
   - un circuit de commande (51) de la tension électrique aux bornes de la bobine (32), dite « tension bobine » ($U_{BOB}$), le circuit de commande comprenant un dispositif dit « de retombée » (Dz), activable sélectivement pour faire chuter le courant électrique circulant au travers de la bobine (32), dit « courant bobine » ($I_{BOB}$), la tension bobine et le dispositif de retombée étant activés ou désactivés selon des états du circuit de commande (51) ;
   - des capteurs (Rsh, 50) pour mesurer le courant bobine et la tension bobine ;
   - un dispositif électronique de contrôle (40), configuré pour recevoir des ordres d'ouverture et de fermeture de l'appareil de commutation, pour recevoir les valeurs des mesures de courant bobine et de tension bobine et pour commander les états du circuit de commande ;

   dans lequel l'appareil de commutation est configuré pour mettre en oeuvre un procédé de diagnostic comportant des étapes consistant à :

a) recevoir (102) un ordre d'ouverture de l'appareil de commutation ;
b) commander (104) l'ouverture de l'actionneur électromagnétique (30) ;
c) mesurer et enregistrer (106) les valeurs de tension bobine ($I_{BOB}$) et de courant bobine ($U_{BOB}$) ;
d) calculer et enregistrer (112) des valeurs d'un flux magnétique ($\phi$) traversant la bobine (32), par intégration des valeurs enregistrées du courant bobine, de la tension bobine et des valeurs, préalablement enregistrées dans le dispositif électronique de contrôle, de résistance ($R_{BOB}$) et d'inductance ($L_{BOB}$) de la bobine ;
e) évaluer et enregistrer (114) des positions (x) du noyau (34) en fonction d'une table de données caractéristique de l'actionneur électromagnétique (30), la table de données étant préalablement enregistrée dans le dispositif électronique et définissant une relation bijective entre la position (x) du noyau (34), le flux magnétique ($\phi$) et le courant bobine ($I_{BOB}$).

**Patentansprüche**

1. Verfahren zur Diagnose eines Betriebszustands eines Schaltgeräts (1), das so konfiguriert ist, dass es mit einem elektrischen Leiter (20) gekoppelt werden kann, und das umfasst:

- trennbare Kontakte (24, 28), die dem elektrischen Leiter zugeordnet sind und von einem elektromagnetischen Aktuator (30) angesteuert werden, der eine Spule (32) umfasst, die mit einer Steuerelektronik (40) verbunden ist, die so konfiguriert ist, dass sie eine Spulenspannung ($U_{SPU}$) zur Steuerung an die Anschlüsse der Spule anlegt,
- Sensoren (Rsh, 50), die so konfiguriert sind, dass sie die Spulenspannung ($U_{SPU}$) und eine Intensität eines Spulenstroms ($I_{SPU}$), der in der Spule fließt, messen,
wobei das Verfahren Schritte umfasst, die aus Folgendem bestehen:

**a)** Empfangen (102) eines Öffnungsbefehls des Schaltgeräts, wobei sich das Schaltgerät anfänglich in einem geschlossenen Zustand befindet, wobei der Öffnungsbefehl von der Steuerelektronik empfangen wird;
**b)** nach Erhalt des Öffnungsbefehls das Öffnen des elektromagnetischen Aktuators (30) mittels der Steuerelektronik (40) zu steuern (104);
**c)** während des Umschaltens des Schaltgeräts (1) in den offenen Zustand, Messen und Aufzeichnen (106) der Werte der Spulenspannung ($U_{SPU}$) und des Spulenstroms (ISPU);
**d)** Berechnen und Aufzeichnen (112) der Werte eines magnetischen Flusses ($\Phi$) durch die Spule (32) durch Integration der aufgezeichneten Werte des Spulenstroms, der Spulenspannung und der Werte des Widerstands ($R_{SPU}$) und der Induktivität ($L_{SPU}$) der Spule, die zuvor in der Steuerelektronik aufgezeichnet wurden;

**dadurch gekennzeichnet, dass** das Verfahren ferner den Schritte umfasst, der aus Folgendem besteht:
**e)** aus den aufgezeichneten Werten des magnetischen Flusses ($\Phi$) und des Spulenstroms ($I_{SPU}$), Auswerten und Aufzeichnen (114) von Positionen ($x$) eines Kerns (34) des elektromagnetischen Aktuators (30) in Abhängigkeit von einer Datentabelle, die für den elektromagnetischen Aktuator charakteristisch ist, wobei die Datentabelle zuvor in der Steuerelektronik (40) gespeichert wurde und eine bijektive Beziehung zwischen der Position (x) des Kerns (34), dem magnetischen Fluss ($\Phi$) und dem Spulenstrom ($I_{SPU}$) definiert.

2. Verfahren nach dem vorhergehenden Anspruch, bei dem der Schritt (112) zur Berechnung des magnetischen Flusses ($\Phi$) einen anfänglichen Unterschritt (108), der als Selbstkorrektur bezeichnet wird, gefolgt von einem Unterschritt (110) zur Berechnung umfasst, wobei der Unterschritt Selbstkorrektur darin besteht, solange der Spulenstrom ($I_{SPU}$) größer als ein niedriger Schwellenwert ($I_1$) ist, der seinerseits strikt größer als ein sogenannter "Ausschwingstrom" ($I_S$) ist, unterhalb dessen der bewegliche Kern (34) durch ein Rückstellorgan (36) des elektromagnetischen Aktuators (30) in die offene Position zurückgedrückt wird, einen Anfangswert des magnetischen Flusses ($\Phi$), den sogenannten "Anfangsfluss" ($\Phi_0$) auszuwerten und zu speichern, so dass, wenn der Spulenstrom ($I_{SPU}$) unter den Ausschwingstrom ($I_D$) abnimmt, die Berechnung durch Integration des magnetischen Flusses ($\Phi$) während der Berechnungsphase (110) den Wert des Anfangsflusses ($\Phi_0$) berücksichtigt.

3. Verfahren nach dem vorhergehenden Anspruch, wobei die Steuerelektronik (40) so konfiguriert ist, dass sie, wenn sich das Schaltgerät (1) im geschlossenen Zustand befindet, die Spulenspannung ($U_{SPU}$) so variiert, dass der Spulenstrom ($I_{SPU}$) zwischen dem unteren Schwellenwert ($I_1$) und einem oberen Schwellenwert ($I_2$) variiert, der

strikt höher als der untere Schwellenwert ist, und wobei die Steuerelektronik nach dem Empfang des Öffnungsbefehls das Öffnen des elektromagnetischen Aktuators (30) steuert, wenn der Spulenstrom ($I_{SPU}$) größer oder gleich 80% des oberen Schwellenwerts ($I_2$) ist, vorzugsweise größer als 95%, noch besser größer als 98%.

4. Verfahren nach dem vorhergehenden Anspruch, bei dem die Änderung der Spulenspannung ($U_{SPU}$) periodisch erfolgt, z. B. durch Zerhacken, wobei der Spulenstrom ($I_{SPU}$) ebenfalls periodisch zwischen dem unteren ($I_1$) und dem oberen ($I_2$) Schwellenwert variiert, und bei dem nach dem Empfangen des Öffnungsbefehls die Steuerelektronik (40) das Öffnen des elektromagnetischen Aktuators (30) spätestens nach einer vorbestimmten Zeit steuert, nachdem sie den Öffnungsbefehl erhalten hat, wobei die vordefinierte Zeit gleich einer Periode der Spulenspannung ($U_{SPU}$) ist.

5. Verfahren nach einem der vorhergehenden Ansprüche, bei dem die Steuerelektronik (40) so konfiguriert ist, dass sie eine sogenannte "Rückfallzeit" ($\Delta t$) berechnet, die gleich der Zeit ist, die zwischen dem Zeitpunkt, zu dem die Steuerelektronik das Öffnen des elektromagnetischen Aktuators (30) steuert, und dem Zeitpunkt, zu dem sich der elektromagnetische Aktuator in der offenen Position befindet, verstrichen ist.

6. Verfahren nach einem der vorhergehenden Ansprüche, wobei das Verfahren einen Schritt (116) umfasst, bei dem durch zeitliche Ableitung der in der Steuerelektronik (40) gespeicherten Positionswerte (x) des Schaltgeräts (1) ein Geschwindigkeitsprofil (*v*) der Bewegung des Schaltgeräts und ein Beschleunigungsprofil (*α*) des Schaltgeräts berechnet werden und die Geschwindigkeits- und Beschleunigungsprofile des Schaltgeräts in der Steuerelektronik (40) gespeichert werden.

7. Verfahren nach dem vorhergehenden Anspruch, wobei das Verfahren einen Schritt (118) umfasst, bei dem ein Wert für die sogenannte "Trenngeschwindigkeit" (V1, V2, V3) berechnet wird, der einer Geschwindigkeit (*v*) zum Bewegen des Kerns (34) entspricht, wenn sich der Kern in einer Position befindet, die als "maximale Quetschung" bezeichnet wird und einer Verschiebung des Kerns aus seiner geschlossenen Position in seine offene Position entspricht, die im Wesentlichen gleich 2 mm ist.

8. Verfahren nach einem der Ansprüche 6 oder 7, wobei das Verfahren einen Schritt (118) umfasst, bei dem während der Öffnungsphase des Schaltgeräts (1) ein lokales Minimum (92, 96) der Geschwindigkeit (*v*) des Kerns (34) zwischen dem Beginn der Bewegung des Kerns und dem Zeitpunkt, an dem der Kern in der geöffneten Position anstößt ermittelt wird.

9. Elektrisches Schaltgerät (1) zur Durchführung eines Diagnoseverfahrens gemäß einem der Ansprüche 1 bis 8, wobei das Schaltgerät umfasst:

   - trennbare Kontakte (24, 28), die zwischen einer offenen und einer geschlossenen Position durch einen elektromagnetischen Aktuator (30) bewegt werden, der eine Spule (32) und einen beweglichen Kern (34) umfasst, der mit den trennbaren Kontakten verbunden ist, wobei das Schaltgerät eine Struktur aufweist, die die Erzeugung von Induktionsströmen begrenzt;
   - eine Steuerschaltung (51) der elektrischen Spannung an den Anschlüssen der Spule (32), genannt "Spulenspannung" ($U_{SPU}$), wobei die Steuerschaltung eine sogenannte "Rückfallvorrichtung" (Dz) umfasst, die selektiv aktiviert werden kann, um den durch die Spule (32) fließenden elektrischen Strom, der als "Spulenstrom" ($I_{SPU}$) bezeichnet wird abfallen zu lassen, wobei die Spulenspannung und die Rückfallvorrichtung gemäß den Zuständen der Steuerschaltung (51) aktiviert oder deaktiviert werden;
   - Sensoren (Rsh, 50) zum Messen des Spulenstroms und der Spulenspannung;
   - eine Steuerelektronik (40), die so konfiguriert ist, dass sie Befehle zum Öffnen und Schließen des Schaltgeräts empfängt, die Werte der Messungen des Spulenstroms und der Spulenspannung empfängt und die Zustände der Steuerschaltung steuert;

   wobei das Schaltgerät so konfiguriert ist, dass es ein Diagnoseverfahren durchführt, das die folgenden Schritte umfasst:

   a) Empfangen (102) eines Öffnungsbefehls des Schaltgeräts;
   b) Steuern (104) des Öffnens des elektromagnetischen Aktuators (30);
   c) Messen und Aufzeichnen (106) der Werte für die Spulenspannung ($I_{SPU}$) und den Spulenstrom ($U_{SPU}$);
   d) Berechnen und Aufzeichnen (112) von Werten eines magnetischen Flusses ($\Phi$) durch die Spule (32) durch Integration der aufgezeichneten Werte des Spulenstroms, der Spulenspannung und der zuvor in der Steuerelektronik aufgezeichneten Werte des Widerstands ($R_{SPU}$) und der Induktivität ($L_{SPU}$) der Spule;

e) Auswerten und Aufzeichnen (114) von Positionen (*x*) des Kerns (34) in Abhängigkeit von einer Datentabelle, die für den elektromagnetischen Aktuator (30) charakteristisch ist, wobei die Datentabelle zuvor in der elektronischen Vorrichtung gespeichert wurde und eine bijektive Beziehung zwischen der Position (*x*) des Kerns (34), dem magnetischen Fluss (*Φ*) und dem Spulenstrom ($I_{SPU}$) definiert.

**Claims**

1. A method of diagnosing an operating state of a switching device (1), configured to be coupled to an electrical conductor (20) and comprising:

   - separable contacts (24, 28) associated with the electrical conductor and controlled by an electromagnetic actuator (30) comprising a coil (32) connected to an electronic control device (40), which is configured to apply a control coil voltage ($U_{BOB}$) across the coil,
   - sensors (Rsh, 50) configured to measure the coil voltage ($U_{BOB}$) and a current of a coil current ($I_{BOB}$) flowing in the coil,
   and wherein the method further comprises the steps consisting of:

   **a)** receiving (102) an opening command from the switching device, the switching device initially being in a closed state, the opening command being received by the electronic control device;
   **b)** after receiving the opening command, command (104) the electromagnetic actuator (30) to open by means of the electronic control device (40);
   **c)** while the switching device (1) is switching to the open state, measuring and recording (106) the coil voltage ($U_{BOB}$) and coil current ($I_{BOB}$) values;
   **d)** calculating and recording (112) values of a magnetic flux (*Φ*) passing through the coil (32), by integrating the recorded values of the coil current, the coil voltage and the values of resistance ($R_{BOB}$) and inductance ($L_{BOB}$) of the coil, previously recorded in the electronic control device;

   **characterised in that** the method further comprises the step consisting of:
   **e)** from the recorded values of magnetic flux (*Φ*) and coil current ($I_{BOB}$), evaluate and record (114) positions (*x*) of a core (34) of the electromagnetic actuator (30) as a function of a data table characteristic of the electromagnetic actuator, the data table being previously recorded in the electronic control device (40) and defining a bijective relationship between the position (x) of the core (34), the magnetic flux (*Φ*) and the coil current ($I_{BOB}$).

2. A method according to the preceding claim, in which the step (112) of calculating the magnetic flux (*Φ*) comprises an initial so-called self-correction sub-step (108), followed by a calculation sub-step (110), the self-correction sub-step consisting in, as long as the coil current ($I_{BOB}$) is greater than a low threshold ($I_1$), itself strictly greater than a so-called "stall current" ($I_S$) below which the moving core (34) is pushed back into the open position by a return member (36) of the electromagnetic actuator (30), evaluating and recording an initial value of the magnetic flux (*Φ*), known as the "initial flux" ($Φ_0$), so that when the coil current ($I_{BOB}$) decreases below the stall current ($I_D$), the calculation by integration of the magnetic flux (*Φ*) during the calculation phase (110) takes account of the value of the initial flux ($Φ_0$).

3. A method according to the preceding claim, in which the electronic control device (40) is configured so as, when the switching device (1) is in the closed state, vary the coil voltage ($U_{BOB}$) so that the coil current ($I_{BOB}$) varies between the low threshold ($I_1$) and a high threshold ($I_2$), strictly greater than the low threshold, and in which, after receiving the opening command, the electronic control device commands the electromagnetic actuator (30) when the coil current ($I_{BOB}$) is greater than or equal to 80% of the high threshold ($I_2$), preferably greater than 95% and even more preferably greater than 98%.

4. A method according to the preceding claim, in which the coil voltage ($U_{BOB}$) is varied periodically, for example by chopping, the coil current ($I_{BOB}$) also varying periodically between the low ($I_1$) and high ($I_2$) thresholds, and in which after receiving the opening command, the electronic control device (40) commands the electromagnetic actuator (30) to open at the latest after a predefined time after receiving the opening command, the predefined time being equal to one period of the coil voltage ($U_{BOB}$).

5. A method according to any one of the preceding claims, in which the electronic control device (40) is configured to calculate a so-called "fallback" time ($\Delta t$), equal to the time elapsed between the instant when the electronic control device commands the opening of the electromagnetic actuator (30) and the instant when the electromagnetic actuator is in the open position.

6. A method according to any one of the preceding claims, wherein the method comprises a step (116) of calculating, by time derivation from position values *(x)* of the switchgear (1) recorded in the electronic control device (40), a speed profile *(v)* of movement of the switching apparatus and an acceleration profile *(α)* of the switching apparatus, and recording the speed and acceleration profiles of the switching apparatus in the electronic control device (40).

7. A method according to the preceding claim, in which the method comprises a step (118) consisting in calculating a so-called "separation" velocity value (V1, V2, V3), equal to a velocity *(v)* of movement of the core (34) when the core is in a "maximum crushing" position corresponding to a movement of the core from its closed position to its open position, substantially equal to 2 mm.

8. A method according to any one of claims 6 or 7, in which the method comprises a step (118) consisting of detecting, during the opening phase of the switching device (1), a local minimum (92, 96) of the speed (v) of the core (34) between the start of the movement of the core and the moment when the core abuts in the open position.

9. An electrical switching apparatus (1) for implementing a diagnostic method according to any one of claims 1 to 8, the switching apparatus comprising:

   - separable contacts (24, 28), moved between an open position and a closed position by an electromagnetic actuator (30) comprising a coil (32) and a moving core (34) linked to the separable contacts, the switching device having a structure limiting the generation of induction currents;
   - a control circuit (51) for controlling the electrical voltage at the terminals of the coil (32), referred to as the "coil voltage" ($U_{BOB}$), the control circuit comprising a "fallback" device (Dz) which can be activated selectively to cause the electric current flowing through the coil (32), referred to as the "coil current" ($I_{BOB}$), to fall, the coil voltage and the fallback device being activated or deactivated depending on the states of the control circuit (51)
   - sensors (Rsh, 50) to measure the coil current and coil voltage;
   - an electronic control device (40), configured to receive commands to open and close the switching device, to receive the values of the coil current and coil voltage measurements and to control the states of the control circuit;

   wherein the switching apparatus is configured to implement a diagnostic method comprising the steps of:

   a) receiving (102) an opening command from the switching device;
   b) controlling (104) the opening of the electromagnetic actuator (30);
   c) measuring and recording (106) the coil voltage ($I_{BOB}$) and coil current ($U_{BOB}$) values;
   d) calculating and recording (112) values of a magnetic flux *(Φ)* passing through the coil (32), by integrating the recorded values of the coil current, the coil voltage and the values, previously recorded in the electronic control device, of the resistance ($R_{BOB}$) and inductance ($L_{BOB}$) of the coil;
   e) evaluating and storing (114) positions (x) of the core (34) as a function of a data table characteristic of the electromagnetic actuator (30), the data table being previously stored in the electronic device and defining a bijective relationship between the position (x) of the core (34), the magnetic flux (Φ) and the coil current ($I_{BOB}$).

## FIG.1

**FIG.2**

FIG.3

**FIG.4**

FIG.5

**FIG.6**

FIG.7

Sensivité de Φ par mm d'entrefer vs. NI

FIG.8

FIG.9

FIG.10

**FIG.11**

FIG.12

# RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2584575 A1

- WO 2015189027 A1